# EUROPEAN PATENT APPLICATION

(11) **EP 4 733 915 A1**
(43) Date of publication of application: **29.04.2026**
(21) Application number: 24832320.6
(22) Date of filing: 11.06.2024
(51) Int. Cl.: G06F 3/04842, G06Q 50/10, H04L 12/28, G06F 3/04845, G06T 19/20, G06F 3/0484, G06T 17/05, G09B 29/00, G06N 3/08

(54) **ELECTRONIC DEVICE FOR PROVIDING INTERNET OF THINGS SERVICE AND CONTROL METHOD THEREFOR**

(30) Priority: 27.06.2023 KR 20230082531; 08.09.2023 KR 20230119736
(71) Applicant: Samsung Electronics Co., Ltd., Suwon-si, Gyeonggi-do 16677 (KR)
(72) Inventor: JUNG, Gwanoh, Suwon-si Gyeonggi-do 16677 (KR); KIM, Hyeonjin, Suwon-si Gyeonggi-do 16677 (KR); YOU, Rina, Suwon-si Gyeonggi-do 16677 (KR); YOO, Jungjae, Suwon-si Gyeonggi-do 16677 (KR); YOO, Hyosang, Suwon-si Gyeonggi-do 16677 (KR); LEE, Kyungjun, Suwon-si Gyeonggi-do 16677 (KR); LEE, Goo, Suwon-si Gyeonggi-do 16677 (KR); LEE, Jongmyung, Suwon-si Gyeonggi-do 16677 (KR); JANG, Heonjae, Suwon-si Gyeonggi-do 16677 (KR); JUNG, Hansoo, Suwon-si Gyeonggi-do 16677 (KR); HONG, Seongkook, Suwon-si Gyeonggi-do 16677 (KR); PARK, Sunyoung, Suwon-si Gyeonggi-do 16677 (KR); PARK, Sijun, Suwon-si Gyeonggi-do 16677 (KR); HWANGBO, Hoon, Suwon-si Gyeonggi-do 16677 (KR); KIM, Soyoung, Suwon-si Gyeonggi-do 16677 (KR); KIM, Hyungmin, Suwon-si Gyeonggi-do 16677 (KR); KIM, Hojin, Suwon-si Gyeonggi-do 16677 (KR); MIN, Jungho, Suwon-si Gyeonggi-do 16677 (KR); JUNG, Heerok, Suwon-si Gyeonggi-do 16677 (KR); CHO, Insung, Suwon-si Gyeonggi-do 16677 (KR); CHA, Janghyuk, Suwon-si Gyeonggi-do 16677 (KR); HONG, Youngtaek, Suwon-si Gyeonggi-do 16677 (KR); KIM, Seokhyun, Suwon-si Gyeonggi-do 16677 (KR); PARK, Junhyung, Suwon-si Gyeonggi-do 16677 (KR); SOHN, Jeonghyo, Suwon-si Gyeonggi-do 16677 (KR); LEE, Donghyun, Suwon-si Gyeonggi-do 16677 (KR); JEON, Daewook, Suwon-si Gyeonggi-do 16677 (KR)
(74) Representative: Gulde & Partner
(86) International application number: PCT/KR2024/007937
(87) International publication number: WO 2025/005540

(57) **Abstract**

According to an embodiment, an electronic device comprises: a communication module; a display; and at least one processor operatively connected to the communication module and the display, wherein the at least one processor may obtain an indoor map, on the basis of a user account, through the communication module, automatically arrange, on the indoor map, one or more objects respectively corresponding to one or more external electronic devices registered in the user account, and display, on the display, the indoor map in which the one or more objects are arranged.

## Description

### [Technical Field]

Embodiments of the disclosure relate to an electronic device providing internet of things (IoT) services and a method of controlling the same.

### [Background Art]

More and more services and additional functions are being provided through electronic devices, e.g., smartphones, or other portable electronic devices. To meet the needs of various users and raise use efficiency of electronic devices, communication service carriers or device manufacturers are jumping into competitions to develop electronic devices with differentiated and diversified functionalities. Accordingly, various functions that are provided through electronic devices are evolving more and more.

As wireless communication technology develops, devices using artificial intelligence (AI) have been widely introduced. For example, home appliances connected over a network through Internet of things (hereinafter, IoT) technology may utilize artificial intelligence. The IoT technology may provide intelligent Internet technology services that create new values in human life by collecting and analyzing data generated by devices. Through the convergence and combination of existing Internet technologies and various industries, IoT technology may be applied to fields, such as smart homes, smart buildings, smart cities, smart cars, and smart home appliances.

Meanwhile, the home is equipped with various home appliances for user convenience. Various services have been proposed to make manipulation or control of home appliances more convenient by way of IoT technology. The home network technology may provide various services through the home network to users in the home. For example, a user may control various internet of things (IoT) devices (e.g., home appliances to which IoT technology is applied) constituting a home network using a personal electronic device (e.g., a smartphone).

For example, home network technology may display objects of appliances and/or furniture on a map based on the structure of an indoor space to provide users with a similar appearance to the actual environment.

### [Detailed Description of the Invention]

### [Technical Solution]

According to an embodiment, an electronic device may include a communication module, a display, and at least one processor operatively connected to the communication module and the display.

According to an embodiment, the at least one processor may obtain an indoor map based on a user account through the communication module.

According to an embodiment, the at least one processor may automatically arrange, on the indoor map, at least one object corresponding respectively to at least one external electronic device registered in the user account.

According to an embodiment, the at least one processor may display, on the display, the indoor map on which the at least one object is arranged.

According to an embodiment, a method of controlling an electronic device may include obtaining an indoor map based on a user account through a communication module of the electronic device.

According to an embodiment, the method of controlling the electronic device may include automatically arranging, on the indoor map, at least one object corresponding respectively to at least one external electronic device registered in the user account.

According to an embodiment, the method of controlling the electronic device may include displaying the indoor map on which the at least one object is arranged.

According to an embodiment, in a non-transitory computer-readable recording medium storing one or more programs, the one or more programs may include instructions for an electronic device to obtain an indoor map based on a user account through a communication module.

According to an embodiment, the one or more programs may include instructions for the electronic device to automatically arrange, on the indoor map, at least one object corresponding respectively to at least one external electronic device registered in the user account.

According to an embodiment, the one or more programs may include instructions for the electronic device to display, on the display, the indoor map on which the at least one object is arranged.

### [Brief Description of Drawings]

FIG. 1 illustrates an internet of things (IoT) system according to an embodiment.
FIG. 2 is a block diagram illustrating an electronic device in a network environment according to an embodiment.
FIG. 3 is a view illustrating an indoor map providing system according to an embodiment.
FIG. 4 is a view illustrating an operation of generating an indoor map on which objects are arranged by an electronic device according to an embodiment.
FIG. 5A is a view illustrating an operation of obtaining an indoor map based on the structure of an indoor space by an electronic device according to an embodiment.
FIG. 5B is a view illustrating an operation of obtaining an indoor map based on the structure of an indoor space by an electronic device according to an embodiment.
FIG. 6 is a view illustrating an operation of obtaining an indoor map based on a floor plan by an electronic device according to an embodiment.
FIG. 7A is a view illustrating an operation of providing an indoor map on which objects are automatically arranged by an electronic device according to an embodiment.
FIG. 7B is a view illustrating an operation of providing an indoor map on which objects are rearranged based on a user input based on the indoor map illustrated in FIG. 7A.
FIG. 8 is a view illustrating an operation in which an electronic device generates an indoor map on which objects are automatically arranged based on a pre-registered IoT device list through an IoT application according to an embodiment.
FIG. 9A is a view illustrating an operation in which an electronic device automatically arranges an object when an IoT device is lighting according to an embodiment.
FIG. 9B is a view illustrating an operation in which an electronic device automatically arranges an object when an IoT device is a curtain or blind according to an embodiment.
FIG. 9C is a view illustrating an operation in which an electronic device automatically arranges an object when an IoT device is a room control device according to an embodiment.
FIG. 9D is a view illustrating an operation in which an electronic device automatically arranges an object when an IoT device is a door lock according to an embodiment.
FIG. 9E is a view illustrating an operation in which an electronic device automatically arranges an object when an IoT device is a TV according to an embodiment.
FIG. 10A is a view illustrating an operation of automatically arranging an object corresponding to an IoT device whose location is difficult to infer by an electronic device according to an embodiment.
FIG. 10B is a view illustrating an operation of automatically arranging an object corresponding to an IoT device whose location is difficult to infer by an electronic device according to an embodiment.
FIG. 11A is a view illustrating an operation of assigning a pre-registered room to an indoor map through an IoT application of an electronic device according to an embodiment.
FIG. 11B is a view illustrating an operation of assigning objects corresponding to IoT devices included in a pre-registered room to an indoor map through an IoT application of an electronic device according to an embodiment.
FIG. 12 is a view illustrating an operation of selecting objects to be displayed on an indoor map when assigning a pre-registered room to the indoor map through an IoT application of an electronic device according to an embodiment.
FIG. 13A is a view illustrating an operation of changing the location of a room assigned on an indoor map of an electronic device according to an embodiment.
FIG. 13B is a view illustrating an operation of deleting a room assigned on an indoor map of an electronic device according to an embodiment.
FIG. 14A is a view illustrating an operation of changing the location of a room assigned on an indoor map of an electronic device according to an embodiment.
FIG. 14B is a view illustrating a user interface displayed when an input for changing the location of a room assigned on an indoor map of an electronic device to a location where another room is already assigned is received according to an embodiment.
FIG. 14C is a view illustrating an operation of switching locations of a plurality of rooms assigned on an indoor map of an electronic device according to an embodiment.
FIG. 15A is a view illustrating an operation of merging a plurality of rooms on an indoor map of an electronic device according to an embodiment.
FIG. 15B is a view illustrating a user interface displayed when an input for merging a plurality of rooms on an indoor map of an electronic device is received according to an embodiment.
FIG. 15C is a view illustrating a user interface displayed for modifying a room name when an input for merging a plurality of rooms on an indoor map of an electronic device is received according to an embodiment.
FIG. 16A is a view illustrating an operation of arranging an object corresponding to an IoT device not registered in any room on an indoor map through an IoT application of an electronic device according to an embodiment.
FIG. 16B is a view illustrating an operation of arranging an object corresponding to an IoT device not registered in any room on an indoor map through an IoT application of an electronic device according to an embodiment.
FIG. 17A is a view illustrating an operation of changing the form of an object of an electronic device according to an embodiment.
FIG. 17B is a view illustrating an operation of changing the form of an object of an electronic device according to an embodiment.
FIG. 18 is a flowchart illustrating an operation of generating an indoor map on which objects are arranged by an electronic device according to an embodiment.
FIG. 19 is a flowchart illustrating an indoor map control operation of another user based on the authority of the other user according to an embodiment.
FIG. 20 is a view illustrating an editing menu provided to another user based on the authority of the other user according to an embodiment.

### [Mode for Carrying out the Invention]

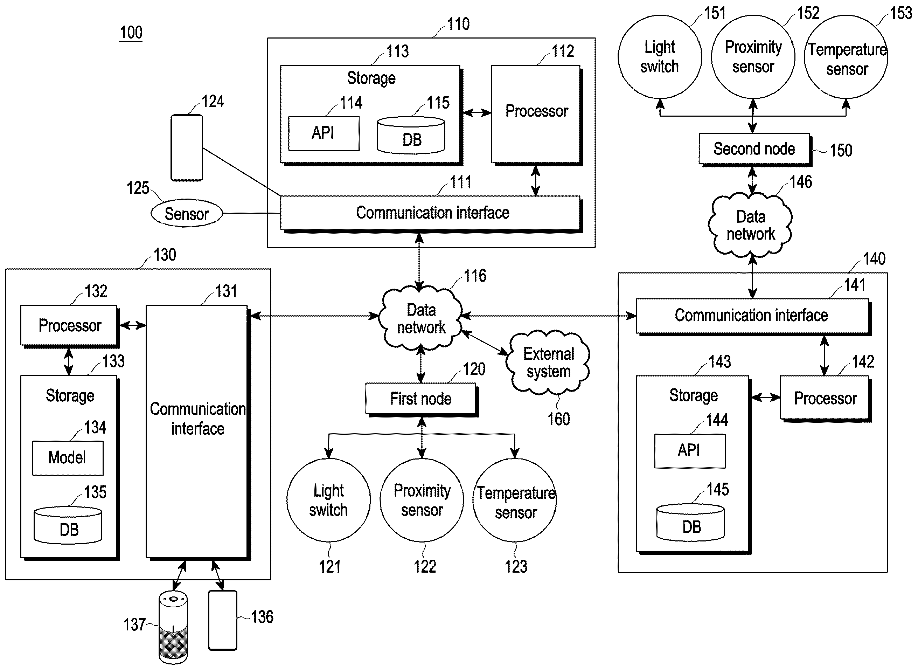

FIG. 1 illustrates an internet-of-things (IoT) system 100 according to an embodiment. At least some of the components shown in FIG. 1 may be omitted, or at least one component not shown may be added.

Referring to FIG. 1, according to an embodiment, the IoT system 100 includes a plurality of electronic devices connectable to a data network 116 or 146. For example, the IoT system 100 may include at least one of a first IoT server 110, a first node 120, a voice assistant server 130, a second IoT server 140, a second node 150, or devices 121, 122, 123, 124, 125, 136, 137, 151, 152, and 153.

According to an embodiment, the first IoT server 110 may include at least one of a communication interface 111, a processor 112, or a storage unit 113. The second IoT server 140 may include at least one of a communication interface 141, a processor 142, or a storage unit 143. In the disclosure, the "IoT server" may remotely control and/or monitor one or more devices (e.g., the devices 121, 122, 123, 124, 125, 136, 137, 151, 152, and 153) directly without a relay device, or via a relay device (e.g., the first node 120 or the second node 150), based on, e.g., a data network (e.g., the data network 116 or data network 146). Here, "device" refers to, e.g., a sensor, home appliance, office electronic device, or processing device placed (or positioned) in a local environment, such as a home, office, factory, building, external place, or other types of sites, and is not limited to a specific type. A device that receives a control command and performs an operation corresponding to the control command may be referred to as a "target device." The IoT server may be referred to as a central server in light that it selects a target device from among a plurality of devices and provides control commands.

According to an embodiment, the first IoT server 110 may communicate with devices 121, 122, and 123 via the data network 116. The data network 116 may mean a network for remote communication, such as, e.g., the Internet or a computer network (e.g., a local area network (LAN) or wide area network (WAN)), or may encompass cellular networks.

According to an embodiment, the first IoT server 110 may connect to the data network 116 via the communication interface 111. The communication interface 111 may include a communication device (or communication module) for supporting communication of the data network 116 and may be implemented as a single integrated component (e.g., a single chip) or as a plurality of separate components (e.g., multiple chips). The first IoT server 110 may communicate with the devices 121, 122, and 123 via the first node 120. The first node 120 may receive data from the first IoT server 110 via the data network 116 and transmit the received data to at least some of the devices 121, 122, and 123. The first node 120 may receive data from at least some of the devices 121, 122, and 123 and transmit the received data to the first IoT server 110 via the data network 116. The first node 120 may function as a bridge between the data network 116 and the devices 121, 122, and 123. Although FIG. 1 illustrates only one first node 120, this is merely an example, and embodiments of the disclosure are not limited thereto.

In the disclosure, "node" may refer to an edge computing system or a hub device. According to an embodiment, the first node 120 may support wired and/or wireless communication of the data network 116 and may support wired and/or wireless communication with the devices 121, 122, and 123. For example, the first node 120 may connect to the devices 121, 122, and 123 via a short-range communication network, e.g., at least one of Bluetooth, Wi-Fi, Wi-Fi direct, Z-wave, Zig-bee, INSETEON, X10, or infrared data association (IrDA), but the type of communication is not limited to a specific one. The first node 120 may be placed (or positioned) in an environment, such as, e.g., a home, office, factory, building, external place, or other types of sites. Thus, the devices 121, 122, and 123 may be monitored and/or controlled by a service provided by the first IoT server 110, and the devices 121, 122, and 123 may not be required to have the capability of full network communication (e.g., Internet communication) for direct connection to the first IoT server 110. Although in the illustrated example, the devices 121, 122, and 123 are implemented as electronic devices in a home environment, such as, e.g., a lamp switch, proximity sensor, and temperature sensor, this is merely an example, and the devices 121, 122, and 123 are not limited thereto.

According to an embodiment, the first IoT server 110 may also support direct communication with devices 124 and 125. Here, "direct communication" may mean communication that does not rely on a relay device, such as the first node 120. For example, "direct communication" may mean communication via, e.g., a cellular communication network and/or data network.

According to an embodiment, the first IoT server 110 may transmit control commands to at least some of devices 121, 122, 123, 124, and 125. Here, "control command" may mean data to trigger a controllable device to perform a specific operation. The specific operation may be an operation performed by a device, including outputting, sensing, reporting, or managing (e.g., deleting or creating) information, but not limited thereto. For example, the processor 112 may obtain information (or a request) for creating a control command from an outside (e.g., at least some of the voice assistant server 130, second IoT server 140, external system 160, or devices 121, 122, 123, 124, and 125) and create a control command based on the obtained information. Alternatively, the processor 112 may create a control command based on a designated condition being met by a result of monitoring of at least some of the devices 121, 122, 123, 124, and 125. The processor 112 may control the communication interface 111 to transmit the control command to the target device.

According to an embodiment, the processor 112, processor 132, or processor 142 may be implemented as a combination of one or more of general-purpose processors, such as central processing units (CPUs), digital signal processors (DSPs), application processors (APs), communication processors (CPs), graphics dedicated processors, such as graphical processing units (GPUs) or vision processing units (VPUs), or artificial intelligence dedicated processors, such as neural processing units (NPUs). The above-described processing units are merely examples. It will be easily appreciated by one of ordinary skill in the art that the processor 112 is not limited thereto as long as it is a computational means capable of executing instructions stored in the memory 113 and outputting the results of execution.

According to an embodiment, the processor 112 may configure a web-based interface based on the API 114 or may expose the resource managed by the first IoT server 110 to the outside. For example, the web-based interface may support communication between the first IoT server 110 and an external web service. For example, the processor 112 may allow the external system 160 to control and/or access the devices 121, 122, and 123. For example, the external system 160 may be an independent (or standalone) system that is not associated with the system 100 or is not part of the system 100. The external system 160 may be, e.g., an external server or website. However, access, by the external system 160, to the devices 121, 122, and 123 or the resource of the first IoT server 110 needs to be secured. According to an embodiment, for automated applications, the processor 112 may expose the API 114-based API end point (e.g., universal resource locator (URL)) to the outside. As set forth above, the first IoT server 110 may transfer the control command to the target device among the devices 121, 122, and 123. The description of the communication interface 141, processor 142, the API 144 of the storage unit 143, and the database 145 of the second IoT server 140 may be substantially the same as the description of the communication interface 111, processor 112, the API 114 of the storage unit 113, and the database 115 of the first IoT server 110. The description of the second node 150 may be substantially the same as the description of the first node 120. The second IoT server 140 may transfer the control command to the target device among the devices 151, 152, and 153. The first IoT server 110 and the second IoT server 140 may be operated by the same service provider in an embodiment but, in another embodiment, the servers 110 and 140, respectively, may be operated by different service providers.

According to an embodiment, the voice assistant server 130 may transmit and receive data to/from the first IoT server 110 via the data network 116. According to an embodiment, the voice assistant server 130 may include at least one of the communication interface 131, processor 132, or storage unit 133. The communication interface 131 may communicate with a smartphone 136 or AI speaker 137 via a data network (not shown) and/or cellular network (not shown). The smartphone 136 or AI speaker 137 may include a microphone and may obtain a user voice, convert the user voice into a voice signal, and transmit the voice signal to the voice assistant server 130. The processor 132 may receive the voice signal from the smartphone 136 or AI speaker 137 via the communication interface 131. The processor 132 may process the received voice signal based on a stored model 134. The processor 132 may create (or identify) a control command using a processing result, based on information stored in the database 135. According to an embodiment, the storage unit 113, 133, or 143 may include, but is not limited to, at least one non-transitory type of storage medium of flash memory types, hard disk types, multimedia card micro types, card-type memories (e.g., secure digital (SD) or extreme digital (XD) memory cards), random access memories (RAMs), static random access memories (SRAMs), read-only memories (ROMs), electrically erasable programmable read-only memories (EEPROMs), programmable read-only memories (PROMs), magnetic memories, magnetic disks, or optical discs.

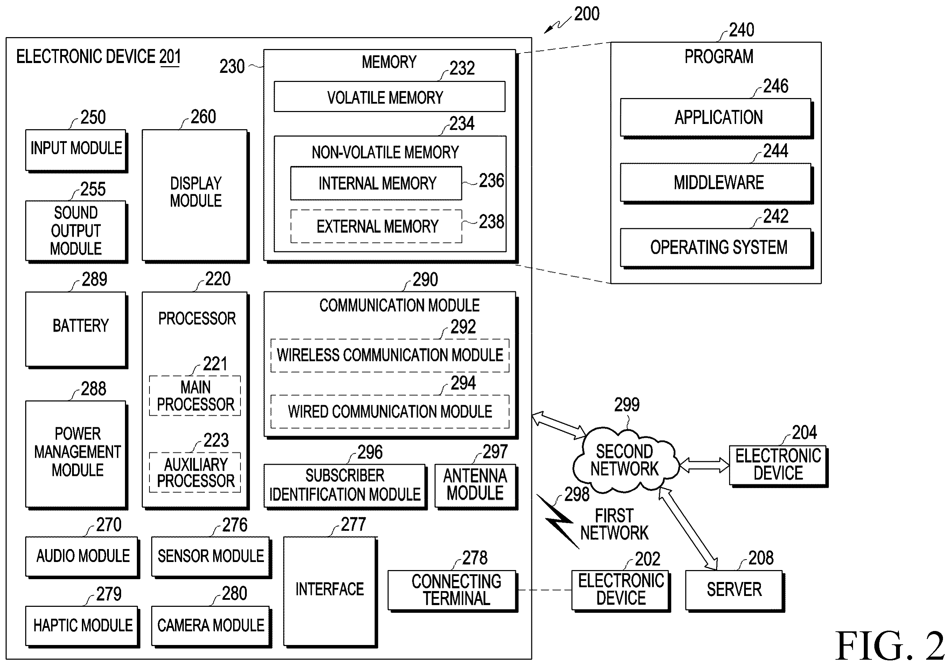

FIG. 2 is a block diagram illustrating an electronic device 201 in a network environment 200 according to various embodiments. Referring to FIG. 2, the electronic device 201 in the network environment 200 may communicate with at least one of an electronic device 202 via a first network 298 (e.g., a short-range wireless communication network), or an electronic device 204 or a server 208 via a second network 299 (e.g., a long-range wireless communication network). According to an embodiment, the electronic device 201 may communicate with the electronic device 204 via the server 208. According to an embodiment, the electronic device 201 may include a processor 220, memory 230, an input module 250, a sound output module 255, a display module 260, an audio module 270, a sensor module 276, an interface 277, a connecting terminal 278, a haptic module 279, a camera module 280, a power management module 288, a battery 289, a communication module 290, a subscriber identification module (SIM) 296, or an antenna module 297. In an embodiment, at least one (e.g., the connecting terminal 278) of the components may be omitted from the electronic device 201, or one or more other components may be added in the electronic device 201. According to an embodiment, some (e.g., the sensor module 276, the camera module 280, or the antenna module 297) of the components may be integrated into a single component (e.g., the display module 260).

The processor 220 may execute, for example, software (e.g., the program 240) to control at least one other component (e.g., a hardware or software component) of the electronic device 201 coupled with the processor 220, and may perform various data processing or computation. According to an embodiment, as at least part of the data processing or computation, the processor 220 may store a command or data received from another component (e.g., the sensor module 276 or the communication module 290) in volatile memory 232, process the command or the data stored in the volatile memory 232, and store resulting data in non-volatile memory 234. According to an embodiment, the processor 220 may include a main processor 221 (e.g., a central processing unit (CPU) or an application processor (AP)), or an auxiliary processor 223 (e.g., a graphics processing unit (GPU), a neural processing unit (NPU), an image signal processor (ISP), a sensor hub processor, or a communication processor (CP)) that is operable independently from, or in conjunction with, the main processor 221. For example, when the electronic device 201 includes the main processor 221 and the auxiliary processor 223, the auxiliary processor 223 may be configured to use lower power than the main processor 221 or to be specified for a designated function. The auxiliary processor 223 may be implemented as separate from, or as part of the main processor 221.

The auxiliary processor 223 may control at least some of functions or states related to at least one component (e.g., the display module 260, the sensor module 276, or the communication module 290) among the components of the electronic device 201, instead of the main processor 221 while the main processor 221 is in an inactive (e.g., sleep) state, or together with the main processor 221 while the main processor 221 is in an active state (e.g., executing an application). According to an embodiment, the auxiliary processor 223 (e.g., an image signal processor or a communication processor) may be implemented as part of another component (e.g., the camera module 280 or the communication module 290) functionally related to the auxiliary processor 223. According to an embodiment, the auxiliary processor 223 (e.g., the neural processing unit) may include a hardware structure specified for artificial intelligence model processing. The artificial intelligence model may be generated via machine learning. Such learning may be performed, e.g., by the electronic device 201 where the artificial intelligence is performed or via a separate server (e.g., the server 208). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 230 may store various data used by at least one component (e.g., the processor 220 or the sensor module 276) of the electronic device 201. The various data may include, for example, software (e.g., the program 240) and input data or output data for a command related thereto. The memory 230 may include the volatile memory 232 or the non-volatile memory 234.

The program 240 may be stored in the memory 230 as software, and may include, for example, an operating system (OS) 242, middleware 244, or an application 246.

The input module 250 may receive a command or data to be used by other component (e.g., the processor 220) of the electronic device 201, from the outside (e.g., a user) of the electronic device 201. The input module 250 may include, for example, a microphone, a mouse, a keyboard, keys (e.g., buttons), or a digital pen (e.g., a stylus pen).

The sound output module 255 may output sound signals to the outside of the electronic device 201. The sound output module 255 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 260 may visually provide information to the outside (e.g., a user) of the electronic device 201. The display module 260 may include, for example, a display, a hologram device, or a projector and control circuitry to control a corresponding one of the display, hologram device, and projector. According to an embodiment, the display module 260 may include a touch sensor configured to detect a touch, or a pressure sensor configured to measure the intensity of a force generated by the touch.

The audio module 270 may convert a sound into an electrical signal and vice versa. According to an embodiment, the audio module 270 may obtain the sound via the input module 250, or output the sound via the sound output module 255 or a headphone of an external electronic device (e.g., an electronic device 202) directly (e.g., wiredly) or wirelessly coupled with the electronic device 201.

The sensor module 276 may detect an operation state (e.g., power or temperature) of the electronic device 201 or an external environmental state (e.g., the user's state), and then generate an electrical signal or data value corresponding to the detected state. According to an embodiment, the sensor module 276 may include, for example, a gesture sensor, a gyro sensor, an atmospheric pressure sensor, a magnetic sensor, an accelerometer, a grip sensor, a proximity sensor, a color sensor, an infrared (IR) sensor, a biometric sensor, a temperature sensor, a humidity sensor, or an illuminance sensor.

The interface 277 may support one or more specified protocols to be used for the electronic device 201 to be coupled with the external electronic device (e.g., the electronic device 202) directly (e.g., wiredly) or wirelessly. According to an embodiment, the interface 277 may include, for example, a high definition multimedia interface (HDMI), a universal serial bus (USB) interface, a secure digital (SD) card interface, or an audio interface.

A connecting terminal 278 may include a connector via which the electronic device 201 may be physically connected with the external electronic device (e.g., the electronic device 202). According to an embodiment, the connecting terminal 278 may include, for example, an HDMI connector, a USB connector, an SD card connector, or an audio connector (e.g., a headphone connector).

The haptic module 279 may convert an electrical signal into a mechanical stimulus (e.g., a vibration or motion) or electrical stimulus which may be recognized by a user via his tactile sensation or kinesthetic sensation. According to an embodiment, the haptic module 279 may include, for example, a motor, a piezoelectric element, or an electric stimulator.

The camera module 280 may capture a still image or moving images. According to an embodiment, the camera module 280 may include one or more lenses, image sensors, image signal processors, or flashes.

The power management module 288 may manage power supplied to the electronic device 201. According to an embodiment, the power management module 288 may be implemented as at least part of, for example, a power management integrated circuit (PMIC).

The battery 289 may supply power to at least one component of the electronic device 201. According to an embodiment, the battery 289 may include, for example, a primary cell which is not rechargeable, a secondary cell which is rechargeable, or a fuel cell.

The communication module 290 may support establishing a direct (e.g., wiredly) communication channel or a wireless communication channel between the electronic device 201 and the external electronic device (e.g., the electronic device 202, the electronic device 204, or the server 208) and performing communication via the established communication channel. The communication module 290 may include one or more communication processors that are operable independently from the processor 220 (e.g., the application processor (AP)) and supports a direct (e.g., wired) communication or a wireless communication. According to an embodiment, the communication module 290 may include a wireless communication module 292 (e.g., a cellular communication module, a short-range wireless communication module, or a global navigation satellite system (GNSS) communication module) or a wired communication module 294 (e.g., a local area network (LAN) communication module or a power line communication (PLC) module). A corresponding one of these communication modules may communicate with the external electronic device 204 via a first network 298 (e.g., a short-range communication network, such as Bluetooth^{™}, wireless-fidelity (Wi-Fi) direct, or infrared data association (IrDA)) or a second network 299 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 292 may identify or authenticate the electronic device 201 in a communication network, such as the first network 298 or the second network 299, using subscriber information (e.g., international mobile subscriber identity (IMSI)) stored in the subscriber identification module 296.

The wireless communication module 292 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 292 may support a high-frequency band (e.g., the mmWave band) to achieve, e.g., a high data transmission rate. The wireless communication module 292 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 292 may support various requirements specified in the electronic device 201, an external electronic device (e.g., the electronic device 204), or a network system (e.g., the second network 299). According to an embodiment, the wireless communication module 292 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 297 may transmit or receive a signal or power to or from the outside (e.g., the external electronic device). According to an embodiment, the antenna module 297 may include one antenna including a radiator formed of a conductor or conductive pattern formed on a substrate (e.g., a printed circuit board (PCB)). According to an embodiment, the antenna module 297 may include a plurality of antennas (e.g., an antenna array). In this case, at least one antenna appropriate for a communication scheme used in a communication network, such as the first network 298 or the second network 299, may be selected from the plurality of antennas by, e.g., the communication module 290. The signal or the power may then be transmitted or received between the communication module 290 and the external electronic device via the selected at least one antenna. According to an embodiment, other parts (e.g., radio frequency integrated circuit (RFIC)) than the radiator may be further formed as part of the antenna module 297.

According to various embodiments, the antenna module 297 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 201 and the external electronic device 204 via the server 208 coupled with the second network 299. The external electronic devices 202 or 204 each may be a device of the same or a different type from the electronic device 201. According to an embodiment, all or some of operations to be executed at the electronic device 201 may be executed at one or more of the external electronic devices 202, 204, or 208. For example, if the electronic device 201 should perform a function or a service automatically, or in response to a request from a user or another device, the electronic device 201, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 201. The electronic device 201 may provide the outcome, with or without further processing of the outcome, as at least part of a reply to the request. To that end, a cloud computing, distributed computing, mobile edge computing (MEC), or client-server computing technology may be used, for example. The electronic device 201 may provide ultra low-latency services using, e.g., distributed computing or mobile edge computing. In another embodiment, the external electronic device 204 may include an Internet-of-things (IoT) device. The server 208 may be an intelligent server using machine learning and/or a neural network. According to an embodiment, the external electronic device 204 or the server 208 may be included in the second network 299. The electronic device 201 may be applied to intelligent services (e.g., smart home, smart city, smart car, or health-care) based on 5G communication technology or IoT-related technology.

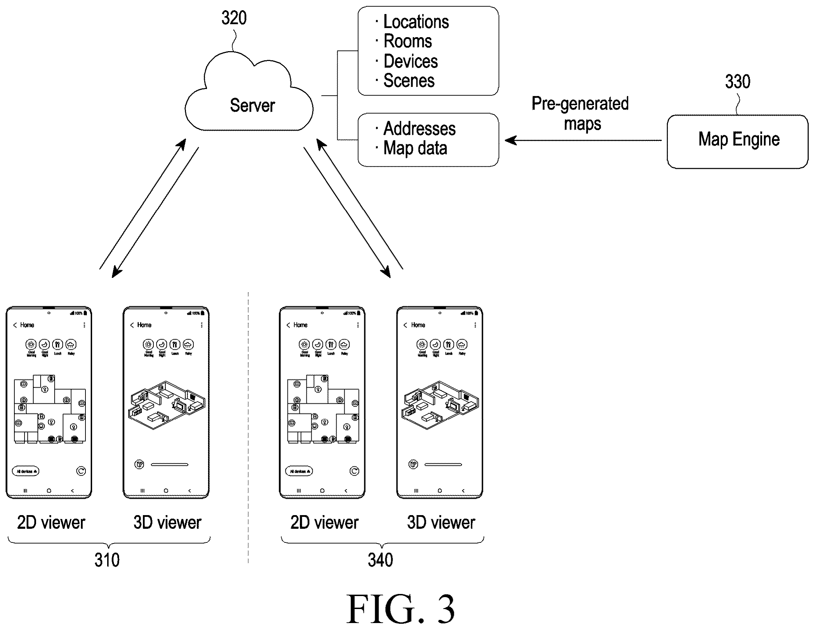

FIG. 3 is a view illustrating an indoor map providing system according to an embodiment.

Referring to FIG. 3, an electronic device 310 (e.g., the device 124 of FIG. 1, the electronic device 201 of FIG. 2, or the processor 220 of FIG. 1) may communicate with a server 320 (e.g., the first IoT server 110 of FIG. 1 or the server 208 of FIG. 2). The server 320 may be a server linked with an application for controlling IoT devices.

According to an embodiment, the electronic device 310 may automatically or manually arrange objects (e.g., furniture and/or IoT devices) on a map (e.g., a 2D viewer or a 3D viewer) generated through an application. The application may be capable of monitoring and controlling the status of IoT devices.

According to an embodiment, the electronic device 310 may receive from the server 320 at least one floor plan identified based on addresses or GPS data stored in a user account.

According to an embodiment, the electronic device 310 may request an indoor map corresponding to a selected floor plan from the server 320 based on receiving a user input selecting one of the at least one floor plan. According to an embodiment, the electronic device 310 may display the indoor map received from the server 320.

According to an embodiment, the server 320 may store, for each user account, information about an indoor space (e.g., a name and/or a size of the indoor space), location information of the indoor space (e.g., an address), information about rooms included in the indoor space, furniture information, and information about linked devices. For example, the information about rooms may include layout information of the rooms (e.g., plane coordinates, wall coordinates, door coordinates, and/or window coordinates).

According to an embodiment, the furniture information may include information about coordinates, size, rotation, and/or display status of furniture included in each room.

According to an embodiment, the information about linked devices may store information about devices grouped and stored by room. The information about linked devices may also include information about devices not included in any room.

According to an embodiment, the electronic device 310 may receive from the server 320 information about the indoor space, information about rooms included in the indoor space, furniture information, and information about linked devices. According to an embodiment, the electronic device 310 may automatically arrange objects corresponding to each of the linked devices on the displayed indoor map.

According to an embodiment, the electronic device 310 may customize the indoor map based on a user input. For example, the electronic device 310 may change the position of or delete automatically arranged objects based on a user input. The electronic device 310 may add an object based on a user input. The electronic device 310 may change the position of, add, and/or delete a room based on a user input.

According to an embodiment, the electronic device 310 may identify the status or notifications of IoT devices through objects included in the indoor map displayed on an execution screen of the application. The electronic device 310 may control IoT devices through the objects.

According to an embodiment, the electronic device 310 may transmit the generated indoor map to the server 320. According to an embodiment, the electronic device 310 may share the generated indoor map with an electronic device 340 of another user through the server 320. The electronic device 340 of the other user may display the indoor map (e.g., a 2D viewer or a 3D viewer) shared through the server 320. The electronic device 340 of the other user may have different functions that may be performed through the indoor map according to authority.

According to an embodiment, the server 320 may store a plurality of indoor maps. According to an embodiment, the plurality of indoor maps may be pre-generated by a map engine 330.

According to an embodiment, the map engine 330 may obtain vector-type map data based on raster-type floor plan images. The raster type may be image data composed of a continuous set of pixels. The vector type may be image data composed of relative positions of continuous points or vertices.

According to an embodiment, the map engine 330 may classify a floor plan image as orthogonal, diagonal, or curved. Through deep learning/machine learning technology, it may recognize spatial structures such as rooms, walls, and doors from floor plan images.

According to an embodiment, the map engine 330 may convert the recognized spatial structure information into vector-type map data. According to an embodiment, the map engine 330 may obtain map data that vectorizes spatial structure information based on whether the floor plan image is linear, diagonal, or curved.

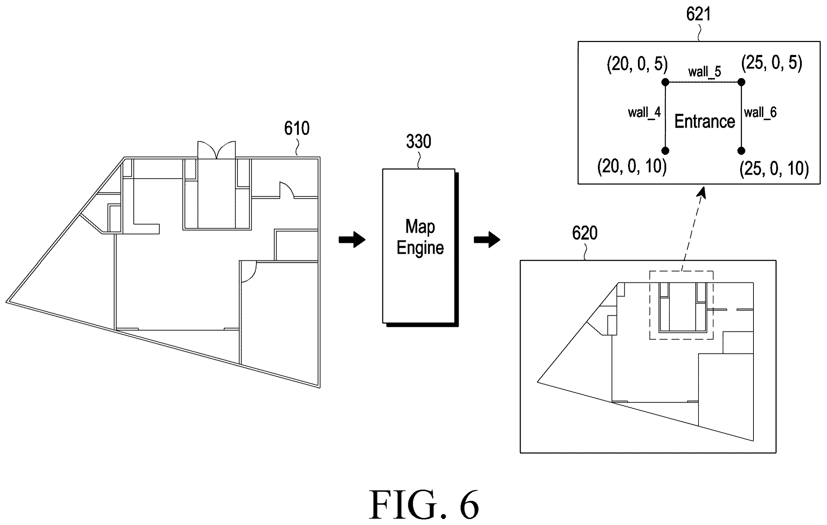

According to an embodiment, the map data acquisition operation of the map engine 330 is described in more detail with reference to FIG. 6 below.

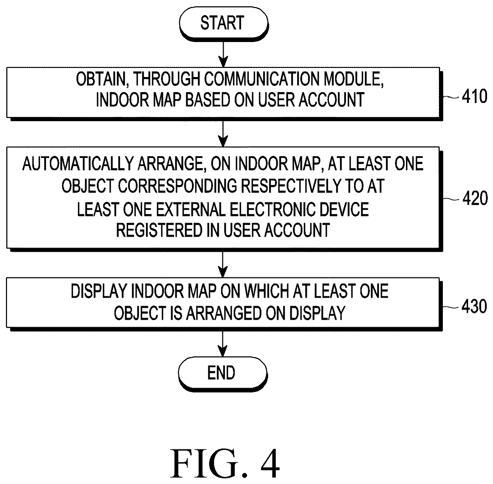

FIG. 4 is a view illustrating an operation of generating an indoor map on which objects are arranged by an electronic device according to an embodiment.

Referring to FIG. 4, in operation 410, an electronic device (e.g., the device 124 of FIG. 1, the electronic device 201 of FIG. 2, the processor 220 of FIG. 1, or the electronic device 310 of FIG. 3) may obtain an indoor map based on a user account through a communication module (e.g., the communication module 290 of FIG. 2).

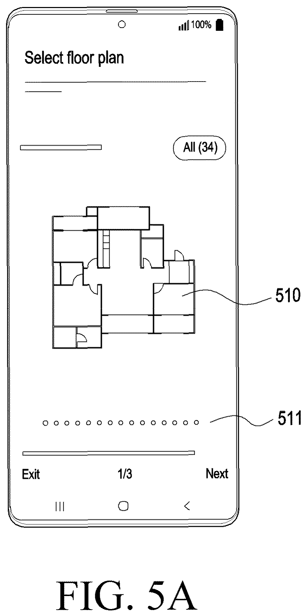

According to an embodiment, the electronic device may provide (e.g., display) at least one floor plan based on address information stored in the user account. For example, the electronic device may display a floor plan as illustrated in FIG. 5A below. According to an embodiment, the at least one floor plan may correspond to address information among a plurality of floor plans stored in a server (e.g., the first IoT server 110 of FIG. 1, the server 208 of FIG. 2, or the server 320 of FIG. 3).

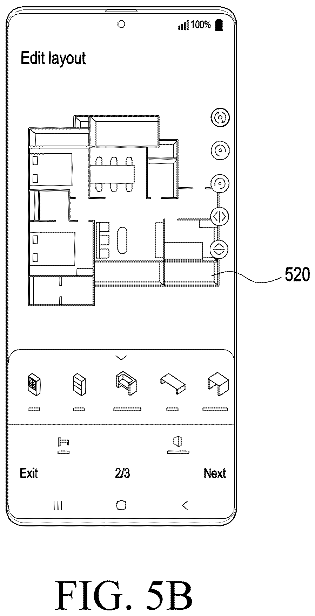

According to an embodiment, the electronic device may provide (e.g., display) an indoor map corresponding to a selected floor plan based on a user input selecting one of the at least one floor plan. For example, the electronic device may display an indoor map as illustrated in FIG. 5B below.

According to an embodiment, the indoor map may be obtained based on the floor plan. For example, the indoor map may be pre-generated based on the floor plan by a map engine connected to the server. According to an embodiment, the operation of the map engine generating an indoor map using a floor plan is described in more detail with reference to FIG. 6 below.

According to an embodiment, the electronic device may obtain an indoor map corresponding to a floor plan based on a deep learning model stored in memory of the electronic device. According to an embodiment, the electronic device may recognize a structure of a space including at least one of a room, a wall, or a door included in a floor plan image based on the deep learning model stored in the memory. For example, the deep learning model may be trained to obtain a structure of a space as output data using a floor plan image as input data.

According to an embodiment, the electronic device may classify the purpose of each of a plurality of spaces included in the indoor map based on the structure of the space. For example, the electronic device may classify each of the plurality of spaces included in the indoor map as a living room, a bathroom, a kitchen, a dining room, a utility room, a pantry, a balcony, a dressing room, a powder room, a bedroom, or an entrance.

According to an embodiment, in operation 420, the electronic device may automatically arrange, on the indoor map, at least one object corresponding respectively to at least one external electronic device registered in the user account.

According to an embodiment, the electronic device may automatically arrange external electronic devices (or IoT devices) registered in the user account on the indoor map. For example, the electronic device may automatically arrange objects corresponding to each of the IoT devices on the indoor map. According to an embodiment, a user may identify the status of the IoT devices through objects corresponding to each of the IoT devices. According to an embodiment, the IoT devices may be controlled based on a user input through objects corresponding to each of the IoT devices.

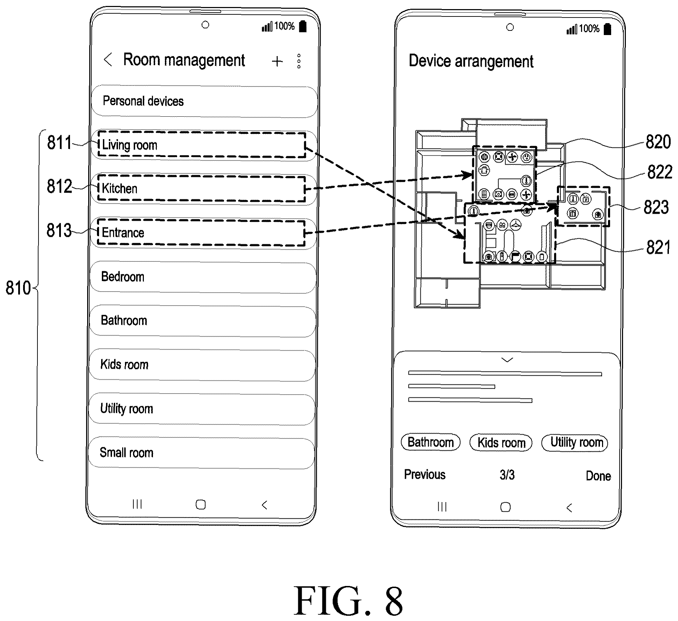

According to an embodiment, the electronic device may automatically arrange objects on the indoor map based on a pre-registered IoT device list. For example, the pre-registered IoT device list may include a room list, and IoT devices included in each room may be grouped by room. According to an embodiment, the operation of automatically arranging objects on the indoor map based on the pre-registered IoT device list is described in more detail with reference to FIG. 8 below.

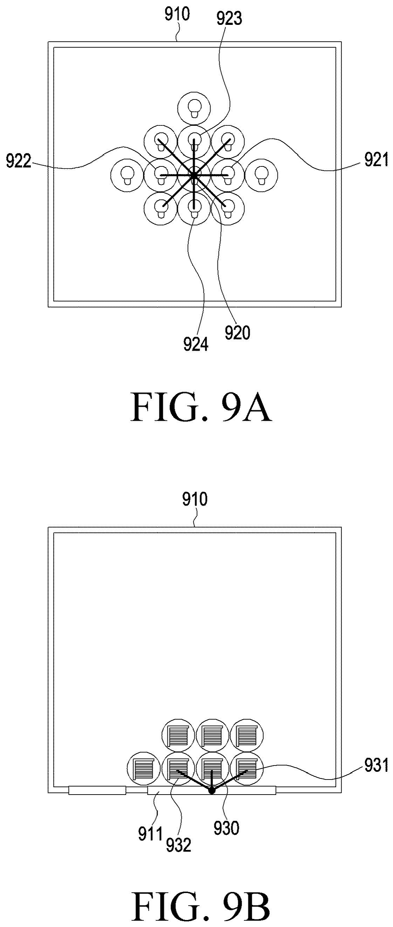

According to an embodiment, the electronic device may automatically arrange the at least one object at a set location on the indoor map based on a set condition corresponding to a type of the at least one external electronic device. For example, when the external electronic device is one of lighting, a blind, a curtain, a room controller, a door lock, a ceiling-embedded device, or a TV, the electronic device may automatically arrange the object at a set location on the indoor map according to the type of the external electronic device. According to an embodiment, the operation of automatically arranging objects based on the type of external electronic device is described in more detail with reference to FIGS. 9A to 9E below.

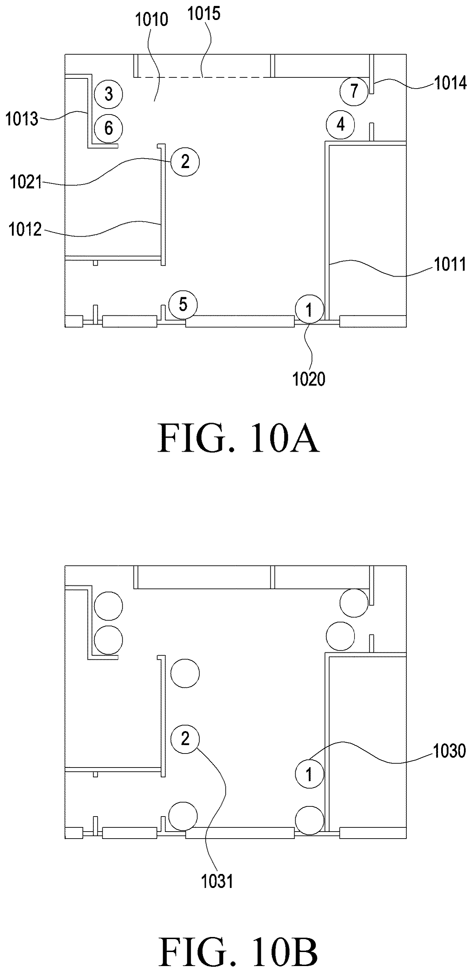

According to an embodiment, the electronic device may arrange an object corresponding to an external electronic device that does not have a set location among the at least one external electronic device in a corner region of a space included in the indoor map. For example, when there is no object arrangement condition according to the type of external electronic device, it may be arranged at the corner of each space. For example, the electronic device may preferentially arrange an object corresponding to an external electronic device that does not have a set location among the at least one external electronic device in a corner region of the longest wall among walls constituting a space included in the indoor map. This allows objects to be arranged with spacing between each other, and may prevent erroneous input when the position is adjusted by the user. According to an embodiment, the operation of automatically arranging objects when there is no object arrangement condition according to the type of external electronic device is described in more detail with reference to FIGS. 10A and 10B below.

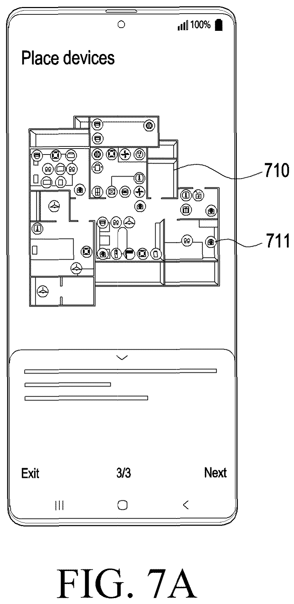

According to an embodiment, in operation 430, the electronic device may display on the display the indoor map on which the at least one object is arranged. For example, as illustrated in FIG. 7A below, the electronic device may provide (e.g., display) an indoor map on which a plurality of objects corresponding to a plurality of registered IoT devices are automatically arranged.

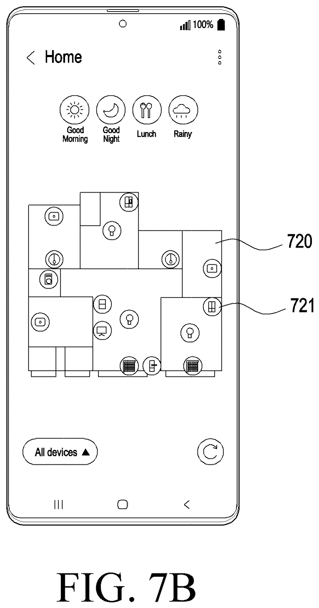

According to an embodiment, the electronic device may provide (e.g., display) an indoor map customized by a user input from the indoor map as illustrated in FIG. 7A, as illustrated in FIG. 7B below.

According to an embodiment, the electronic device may customize the indoor map on which the plurality of objects are automatically arranged based on a user input. For example, the electronic device may add, delete, change the position, and/or change the form of an object based on a user input. According to an embodiment, the electronic device may add, delete, change the position, and/or change the form of a room based on a user input.

According to an embodiment, the electronic device may rearrange at least one space among a plurality of spaces included in the indoor map based on receiving a user input for rearranging a space of the indoor map.

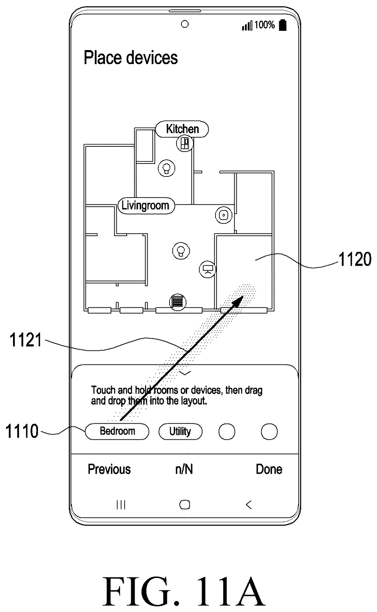

According to an embodiment, the electronic device may assign a room to a region included in the indoor map. For example, when a user input is received that selects one room included in a room list and drags it to one region included in the indoor map, the electronic device may assign the selected room to the region where the drag is released. According to an embodiment, the operation of assigning a room is described in more detail with reference to FIG. 11A below.

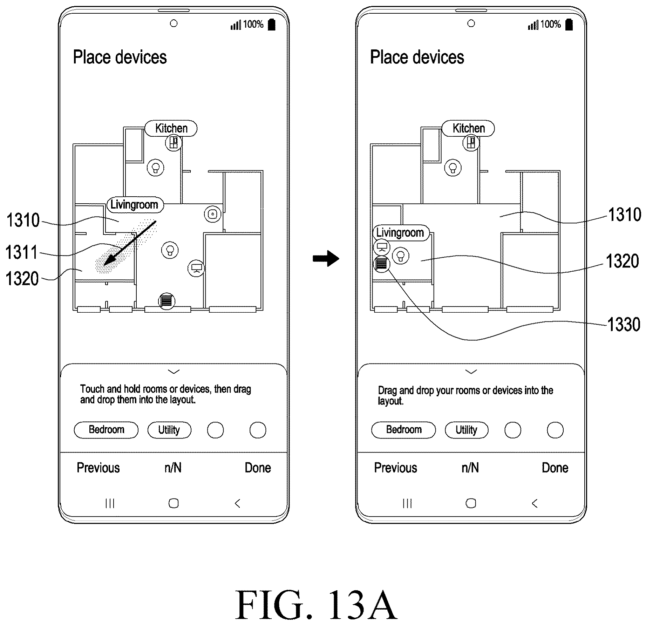

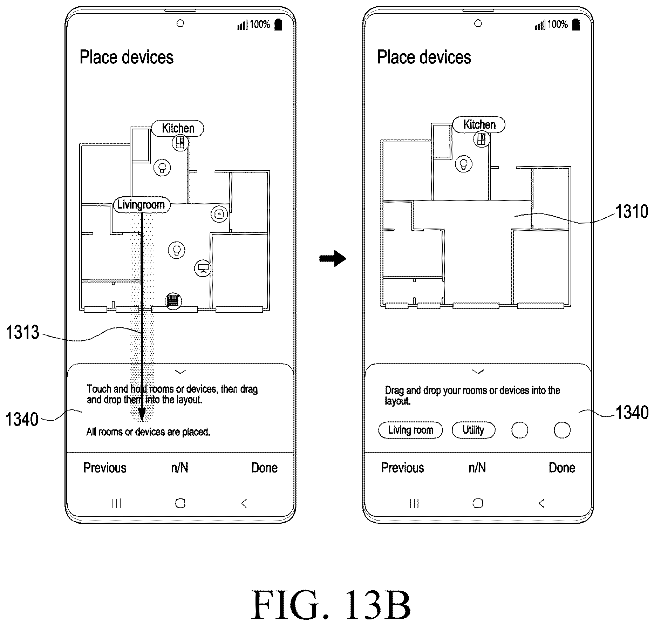

According to an embodiment, the electronic device may change a room assigned to one region included in the indoor map to be assigned to another region or unassign the room assigned to the region based on a user input. According to an embodiment, the operation of changing or unassigning the assigned region of a room is described in more detail with reference to FIGS. 13A and 13B below.

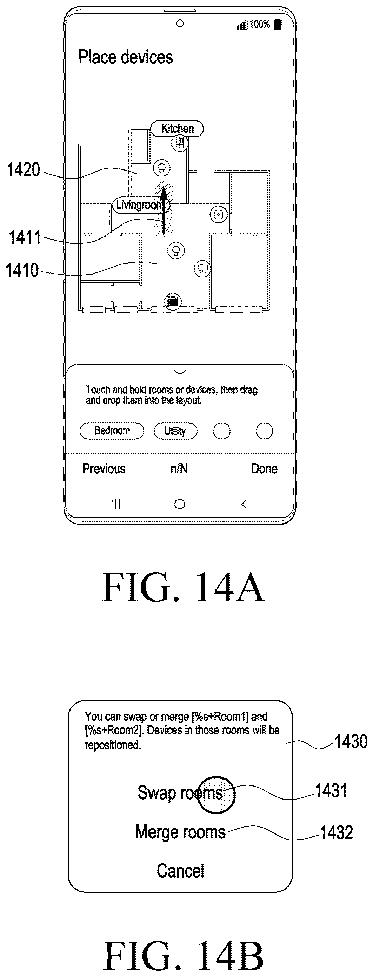

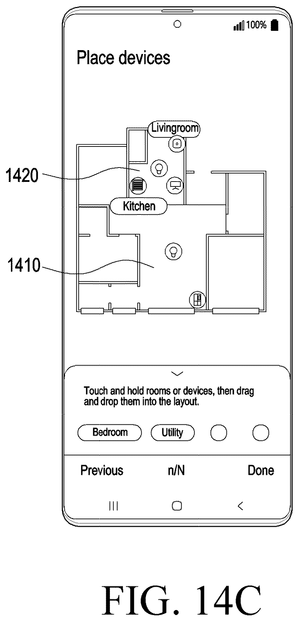

According to an embodiment, the electronic device may switch the assigned regions of a plurality of rooms assigned to each of a plurality of regions included in the indoor map based on a user input. According to an embodiment, the operation of switching the locations of a plurality of assigned regions is described in more detail with reference to FIGS. 14A, 14B, and 14C below.

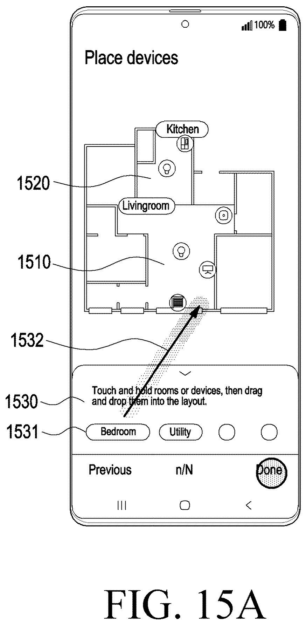

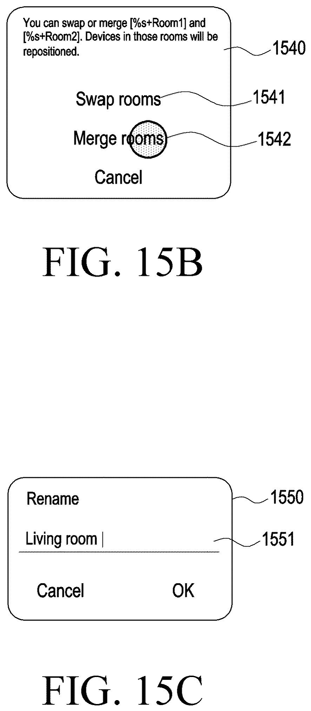

According to an embodiment, the electronic device may change a plurality of rooms assigned to each of a plurality of regions included in the indoor map to be assigned to one region based on a user input. According to an embodiment, the operation of merging a plurality of assigned regions into one region is described in more detail with reference to FIGS. 15A, 15B, and 15C below.

According to an embodiment, the electronic device may rearrange the one object based on receiving a user input for moving the location of one object among the at least one object. For example, the electronic device may move the position of a selected object based on a user input selecting and dragging a displayed object.

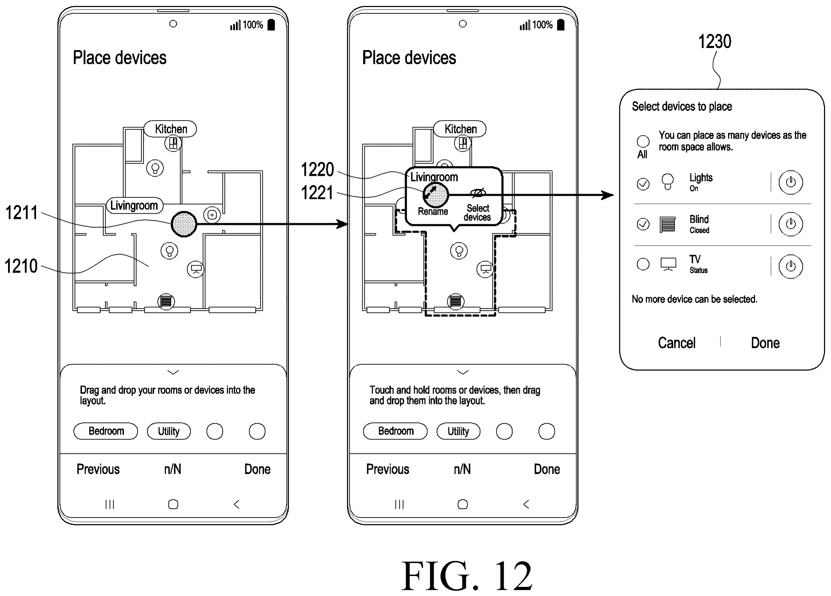

According to an embodiment, the electronic device may select an object to be displayed in a room assigned to one region included in the indoor map based on a user input. For example, when selecting a room assigned to one region included in the indoor map, the electronic device may display a plurality of IoT devices included in the room. The electronic device may display at least one object corresponding to each of at least one IoT device selected from among the plurality of IoT devices in one region of the indoor map. According to an embodiment, the operation of selecting an object to be displayed among a plurality of objects is described in more detail with reference to FIG. 12 below.

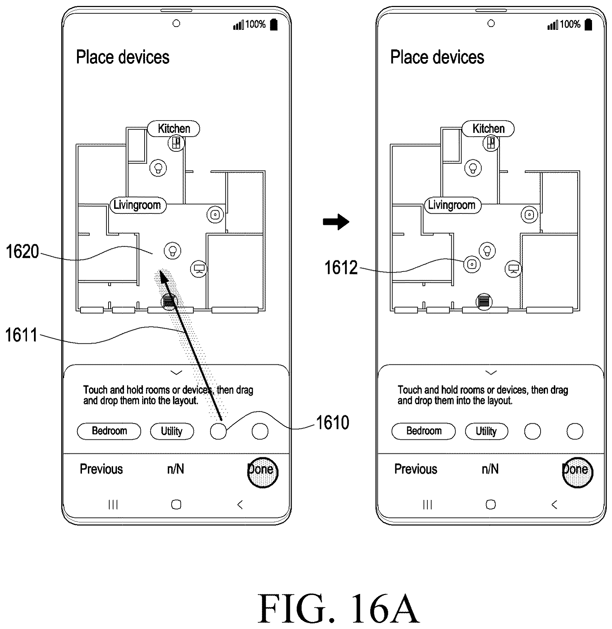

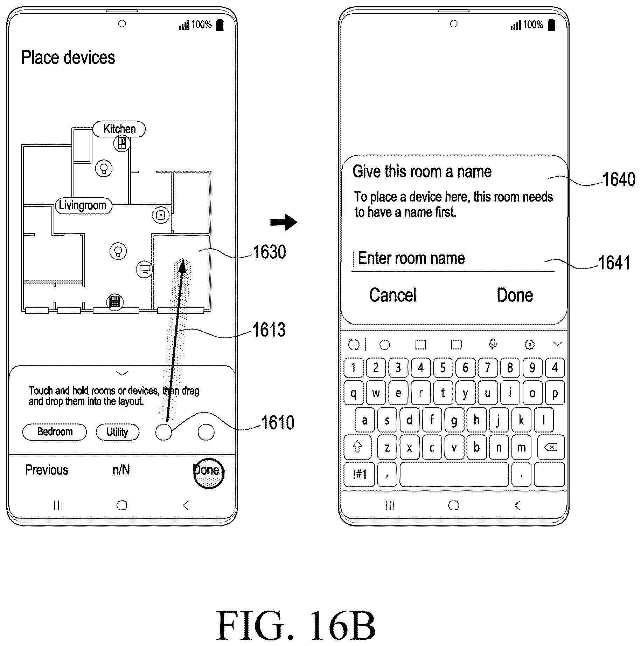

According to an embodiment, the electronic device may add an object of an IoT device not included in a room from an IoT device list to a room assigned to one region included in the indoor map based on a user input. According to an embodiment, the operation of adding an object not displayed on the indoor map is described in more detail with reference to FIGS. 16A and 16B below.

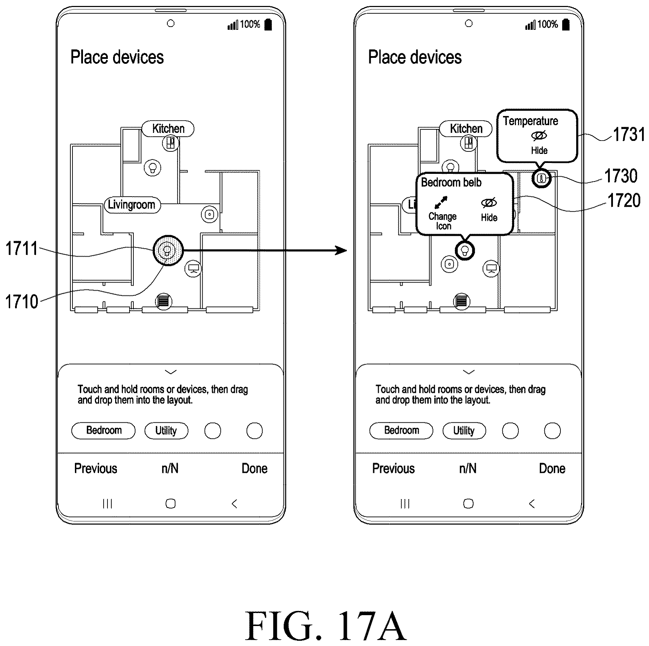

According to an embodiment, the electronic device may hide an object displayed on the indoor map based on a user input. For example, the electronic device may maintain the IoT device included in the room but delete only the object displayed on the indoor map. According to an embodiment, the operation of hiding an object displayed on the indoor map is described in more detail with reference to FIG. 17A below.

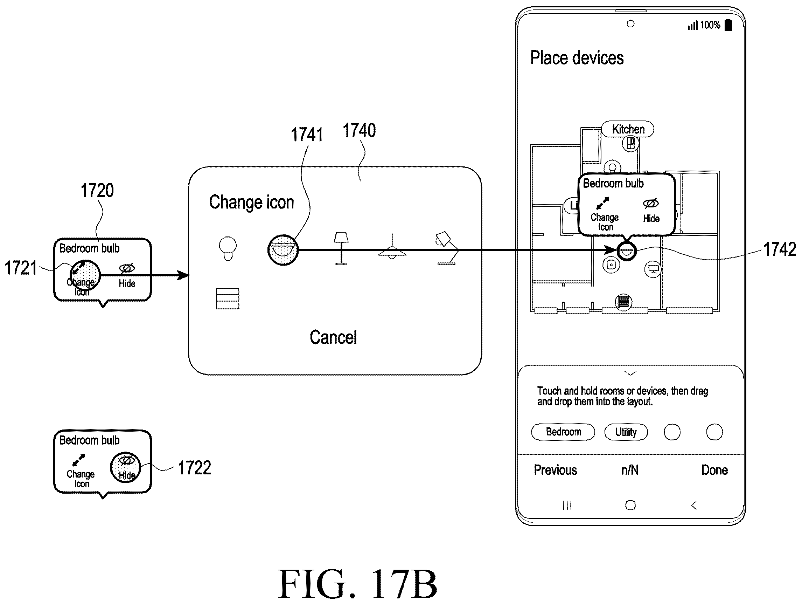

According to an embodiment, the electronic device may change the object form based on a user input. For example, when selecting an object for a long time, the electronic device may display an icon list. According to an embodiment, the electronic device may change the form of the object to an icon selected from the icon list. According to an embodiment, the operation of changing the form of an object is described in more detail with reference to FIG. 17B below.

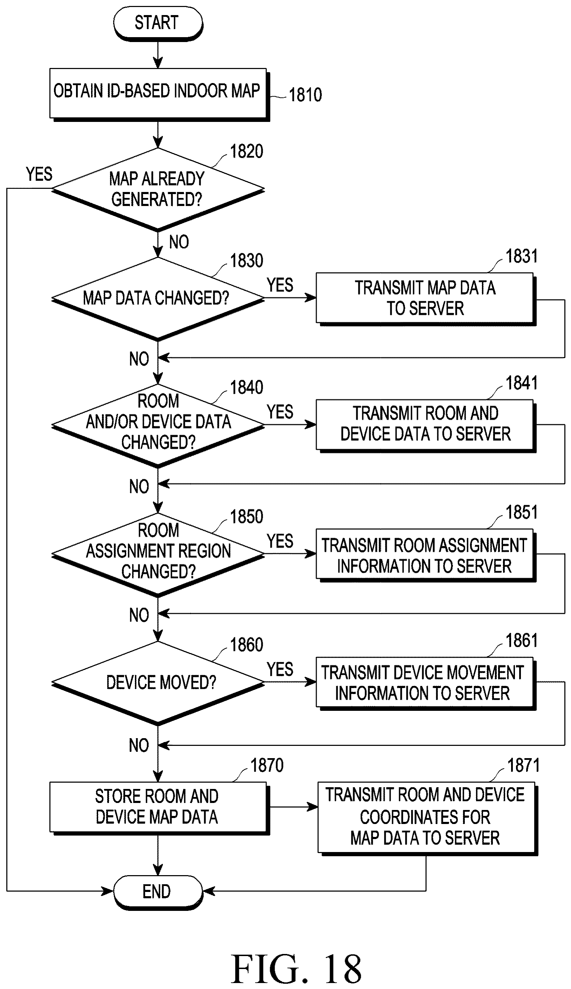

According to an embodiment, the electronic device may transmit the indoor map generated based on a user input to the server. For example, when a room assignment region is changed or an object is changed based on a user input, the electronic device may transmit change information to the server to update the indoor map. According to an embodiment, the operation of transmitting an indoor map updated based on a user input to the server is described in more detail with reference to FIG. 18 below.

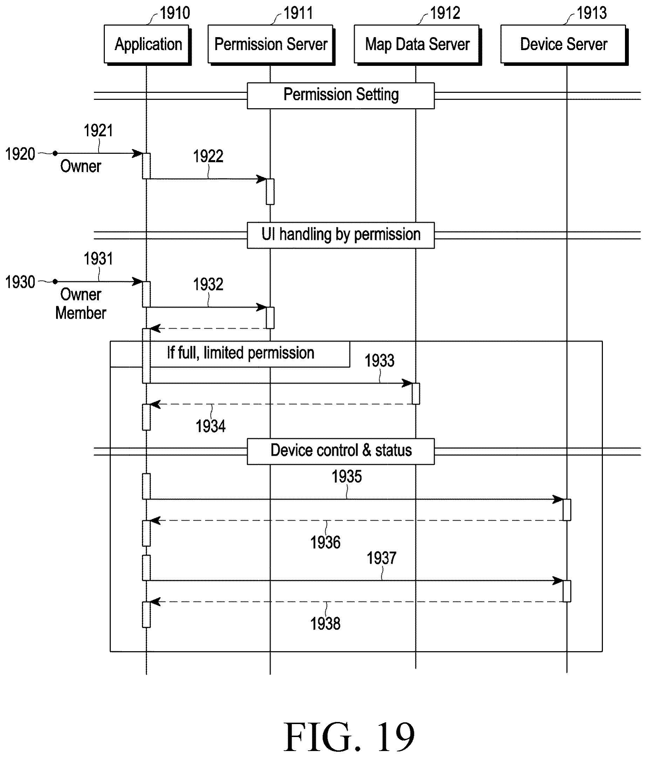

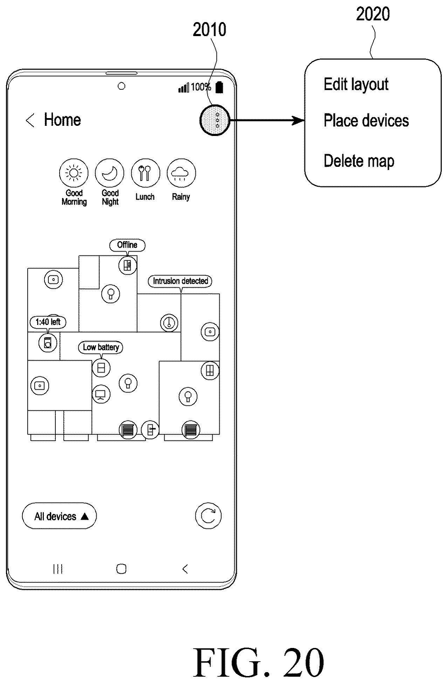

According to an embodiment, the electronic device may share the indoor map on which the at least one object is arranged with an external electronic device through the communication module. For example, the external electronic device may be an electronic device of another user. According to an embodiment, the electronic device of the other user may have different functions that may be performed through the indoor map according to authority. According to an embodiment, the operation of sharing the indoor map with the electronic device of the other user is described in more detail with reference to FIGS. 19 and 20 below.

FIG. 5A is a view illustrating an operation of obtaining an indoor map based on the structure of an indoor space by an electronic device according to an embodiment.

Referring to FIG. 5A, an electronic device (e.g., the device 124 of FIG. 1, the electronic device 201 of FIG. 2, the processor 220 of FIG. 1, or the electronic device 310 of FIG. 3) may provide (e.g., display) at least one floor plan based on a user account. For example, the electronic device may display at least one floor plan selected based on address information included in the user account from among a plurality of floor plans stored in a floor plan database of a server (e.g., the first IoT server 110 of FIG. 1, the server 208 of FIG. 2, or the server 320 of FIG. 3).

According to an embodiment, the electronic device may further display a UI 511 related to the at least one floor plan. The UI 511 related to the at least one floor plan may include information about the number of at least one floor plans and the order of a currently displayed floor plan 510. For example, the electronic device may sequentially display floor plans one by one based on receiving a swipe operation. According to an embodiment, the at least one floor plan may also be displayed in a list form.

According to an embodiment, the electronic device may receive a user input selecting one of the at least one floor plan. For example, the electronic device may select a floor plan 510 corresponding to an indoor space based on a user input from among floor plans of various structures. For example, a user input selecting one floor plan 510 may include selecting the floor plan 510 and selecting identify (or next), or no other user input being entered for a set time while one floor plan 510 is displayed.

According to an embodiment, the electronic device may transmit information about the selected floor plan 510 to the server.

FIG. 5B is a view illustrating an operation of obtaining an indoor map based on the structure of an indoor space by an electronic device according to an embodiment.

Referring to FIG. 5B, the electronic device may provide (e.g., display) an indoor map 520 corresponding to the selected floor plan. For example, the electronic device may receive and display from the server the indoor map 520 corresponding to the selected floor plan 510 as illustrated in FIG. 5A. According to an embodiment, although the indoor map 520 is illustrated as 2D in FIG. 5B, it may also be displayed in 3D.

According to an embodiment, the indoor map 520 may be one that recognizes spatial structures such as rooms, walls, and doors from the floor plan. For example, the indoor map 520 may include coordinate information for each region of the space.

According to an embodiment, the indoor map 520 may correspond to the selected floor plan among a plurality of indoor maps stored in the server. According to an embodiment, the plurality of indoor maps may be obtained based on a plurality of floor plans by the map engine illustrated in FIG. 6 below.

FIG. 6 is a view illustrating an operation of obtaining an indoor map based on a floor plan by an electronic device according to an embodiment.

Referring to FIG. 6, the map engine 330 (e.g., the map engine 330 of FIG. 3) may obtain an indoor map 620 based on a floor plan image 610. The map engine 330 may obtain information 621 related to the indoor map 620 (e.g., recognition information or coordinate information).

According to an embodiment, the map engine 330 may recognize a structure of a space including at least one of a room, a wall, or a door included in the floor plan image based on a deep learning model stored in memory. The deep learning model may be trained to obtain a structure of a space as output data using a floor plan image as input data.

According to an embodiment, the map engine 330 may classify the floor plan image 610 as orthogonal, diagonal, or curved. Since diagonals and curves increase the complexity of vectorization, the electronic device may classify the type of floor plan image 610 as orthogonal, diagonal, and curved to select an algorithm optimized for each type. This allows the electronic device to enhance the processing speed of vectorization.

For example, the map engine 330 may extract thick black solid lines from the floor plan image 610. The map engine 330 may classify the floor plan image 610 as orthogonal when the angle between adjacent solid lines among the extracted solid lines is 90 degrees and facing solid lines are parallel to each other. According to an embodiment, the map engine 330 may classify the floor plan image 610 as diagonal when the angle between adjacent solid lines among the extracted solid lines is not 90 degrees or facing solid lines are not parallel to each other. According to an embodiment, the map engine 330 may classify the floor plan image 610 as curved if there is a portion where the slope continuously changes among the extracted solid lines.

According to an embodiment, the map engine 330 may identify diagonal or curved portions within the floor plan image 610 based on angles between the extracted solid lines, parallelism, and slope changes.

According to an embodiment, the map engine 330 may recognize spatial structures such as rooms, walls, and doors from the raster-type floor plan image 610 using deep learning or machine learning.

According to an embodiment, when the types of floor plans increase or objects to be recognized other than spatial structure information such as rooms, walls, and doors increase, the deep learning model may be retrained by adding floor plan labeling as training data.

According to an embodiment, the map engine 330 may convert to vector-type map data based on the recognized spatial structure information. For example, the map engine 330 may convert the spatial structure recognized through the deep learning model to coordinate-based map data, generate position coordinates of rooms, walls, and doors, and store as map data 620, 621 by mapping space types (e.g., mapping each region of the indoor map to a bedroom, a living room, a bathroom, etc.).

FIG. 7A is a view illustrating an operation of providing an indoor map on which objects are automatically arranged by an electronic device according to an embodiment.

Referring to FIG. 7A, an electronic device (e.g., the device 124 of FIG. 1, the electronic device 201 of FIG. 2, the processor 220 of FIG. 1, or the electronic device 310 of FIG. 3) may provide (e.g., display) an indoor map 710 on which a plurality of objects 711 are automatically arranged.

For example, the electronic device may automatically arrange objects 711 corresponding to IoT devices registered in a user account and objects corresponding to furniture registered in the user account on the indoor map 710. For example, IoT devices registered in the user account may be grouped by room as illustrated in FIG. 8 below.

According to an embodiment, the electronic device may arrange objects corresponding to IoT devices grouped by room in regions corresponding to rooms on the indoor map. The electronic device may display all objects corresponding to IoT devices grouped by room on the indoor map.

For example, the electronic device may automatically arrange objects corresponding to IoT devices based on set conditions within regions corresponding to rooms. According to an embodiment, the operation of automatically arranging objects within regions corresponding to rooms is described in more detail with reference to FIGS. 9A to 10B below.

FIG. 7B is a view illustrating an operation of providing an indoor map on which objects are rearranged based on a user input based on the indoor map illustrated in FIG. 7A.

Referring to FIG. 7B, the electronic device may provide (e.g., display) an indoor map 720 on which spaces are modified or rearranged and objects 721 are added, deleted, and/or rearranged based on a user input. According to an embodiment, the objects 721 may be arranged at positions on the indoor map 720 corresponding to actual spaces based on changing the region to which a room is assigned or moving the position of objects according to a user input.

According to an embodiment, some objects may be deleted from the indoor map 720 based on a user input. According to an embodiment, the registration of IoT devices corresponding to deleted objects may be maintained.

Thus, by customizing the indoor map based on a user input, it is more similar to the actual space and may more intuitively identify and control the status of IoT devices. Further, by not displaying all objects corresponding to registered IoT devices and displaying only some objects by user selection, the spacing between objects is widened, preventing malfunction in controlling IoT devices through objects.

FIG. 8 is a view illustrating an operation in which an electronic device generates an indoor map on which objects are automatically arranged based on a pre-registered IoT device list through an IoT application according to an embodiment.

Referring to FIG. 8, an electronic device (e.g., the device 124 of FIG. 1, the electronic device 201 of FIG. 2, the processor 220 of FIG. 1, or the electronic device 310 of FIG. 3) may generate an IoT device list 810 through an application for controlling IoT devices. According to an embodiment, the IoT device list 810 may be generated based on a user input. According to an embodiment, the IoT device list 810 may be grouped by room. For example, IoT devices included in the living room may be grouped in a living room item 811. IoT devices included in the kitchen may be grouped in a kitchen item 812. IoT devices included in the entrance may be grouped in an entrance item 813.

According to an embodiment, the electronic device may identify the type of each region included in the indoor map 820 based on spatial structure information included in the indoor map 820.

According to an embodiment, the electronic device may automatically assign room items to each region of the indoor map 820 based on spatial information recognized when generating the indoor map 820 and room items grouped by the user in the application. For example, the electronic device may identify whether the name of room items pre-registered in the application matches the name of the type of each region included in the indoor map. The electronic device may assign room items that match the name of the type of region to the region. For example, the living room item 811 of the IoT device list 810 may be assigned to a living room region 821 on the indoor map 820. The kitchen item 812 of the IoT device list 810 may be assigned to a kitchen region 822 on the indoor map 820. The entrance item 813 of the IoT device list 810 may be assigned to an entrance region 823 on the indoor map 820.

According to an embodiment, the electronic device may arrange objects corresponding respectively to IoT devices included in the room item in the region to which the room item is assigned. According to an embodiment, the operation of automatically arranging objects in a region is described in more detail with reference to FIGS. 9A to 10B below.

Thus, by automatically arranging objects corresponding to IoT devices on the indoor map, user convenience is enhanced, and by distributing the objects, malfunction during touch control of objects may be decreased.

FIG. 9A is a view illustrating an operation in which an electronic device automatically arranges an object when an IoT device is lighting according to an embodiment.

Referring to FIG. 9A, an electronic device (e.g., the device 124 of FIG. 1, the electronic device 201 of FIG. 2, the processor 220 of FIG. 1, or the electronic device 310 of FIG. 3) may preferentially arrange a first object 910 corresponding to lighting at the center of a room 910 when the IoT device is lighting.

According to an embodiment, if the object may not be arranged at the center, the electronic device may sequentially arrange the object to the right, left, upper, or lower surface of the center. For example, a second object 921 may not be arranged at the center of the room 910 because of the first object 920, so it may be arranged to the right of the center. A third object 922 may not be arranged at the center or to the right of the center of the room 910 because of the first object 920 and the second object 921, so it may be arranged to the left of the center. A fourth object 923 may not be arranged at the center, to the right of the center, or to the left of the center of the room 910 because of the first object 920, the second object 921, and the third object 922, so it may be arranged above the center. A fifth object 924 may not be arranged at the center, to the right of the center, to the left of the center, or above the center of the room 910 because of the first object 920, the second object 921, the third object 922, and the fourth object 923, so it may be arranged below the center.

According to an embodiment, when an object may not be arranged in any of the four directions from the center, the electronic device may sequentially arrange objects in diagonal directions from the center. According to an embodiment, when the electronic device may not arrange an object in any of the diagonal directions from the center, the electronic device may sequentially arrange objects starting from the region closest to the center among arrangeable regions.

FIG. 9B is a view illustrating an operation in which an electronic device automatically arranges an object when an IoT device is a curtain or blind according to an embodiment.

Referring to FIG. 9B, when the IoT device is a curtain or blind, the electronic device may arrange a first object 930 corresponding to the curtain or blind at the center of the longest window 911 in the room 910.

According to an embodiment, if the object may not be arranged at the center of the window 911, the electronic device may sequentially arrange the object to the right, left, or above the center of the window 911. For example, a second object 931 may not be arranged at the center of the window 911 because of the first object 900, so it may be arranged to the right of the center of the window 911. A third object 932 may not be arranged at the center or to the right of the center of the window 911 because of the first object 930 and the second object 931, so it may be arranged to the left of the center of the window 911.

According to an embodiment, when an object may not be arranged to either the left or right of the center of the window 911, the electronic device may arrange the object above the center of the window 911. According to an embodiment, the electronic device may sequentially arrange objects starting from the region closest to the center of the window 911 among arrangeable regions.

According to an embodiment, when the IoT device is a ceiling-embedded device (e.g., an air conditioner, an air purifier), objects may also be automatically arranged on the indoor map under the same conditions as in FIG. 9B.

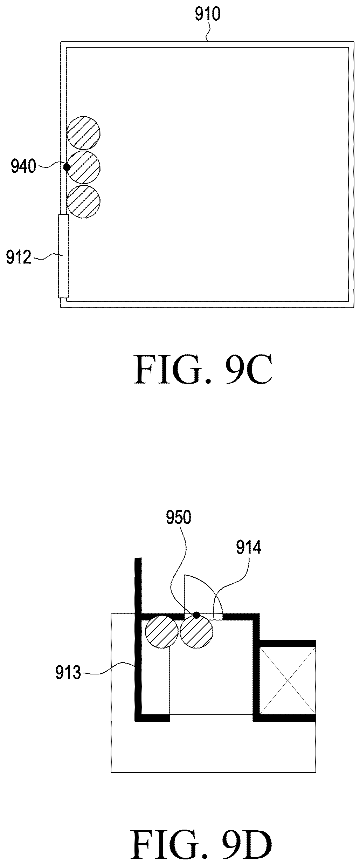

FIG. 9C is a view illustrating an operation in which an electronic device automatically arranges an object when an IoT device is a room controller according to an embodiment.

Referring to FIG. 9C, when the IoT device is a room controller, the electronic device may arrange an object 940 corresponding to the room controller on the longest wall among walls with a door 912 in the room 910. According to an embodiment, the electronic device may arrange the object 940 close to the center of the wall where it is arranged.

According to an embodiment, when the object 940 may not be arranged at the center of the wall, the electronic device may sequentially arrange objects starting from the region closest to the center of the wall among arrangeable regions.

FIG. 9D is a view illustrating an operation in which an electronic device automatically arranges an object when an IoT device is a door lock according to an embodiment.

Referring to FIG. 9D, when the IoT device is a door lock, the electronic device may arrange an object 950 corresponding to the door lock at the center of an external wall door 914 of an entrance 913. According to an embodiment, when there are multiple external wall doors, the electronic device may arrange the object 950 at the door of the longest external wall.

According to an embodiment, when the object 950 may not be arranged at the center of the door 914, the electronic device may sequentially arrange objects starting from the region closest to the center of the door 914 among arrangeable regions.

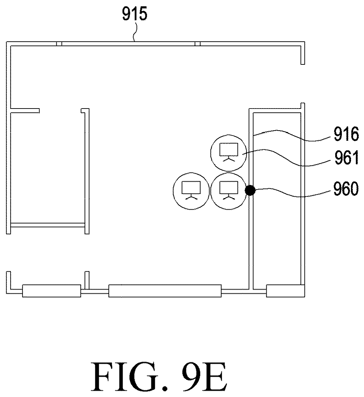

FIG. 9E is a view illustrating an operation in which an electronic device automatically arranges an object when an IoT device is a TV according to an embodiment.

Referring to FIG. 9E, when the IoT device is a TV, the electronic device may arrange an object 950 corresponding to the TV at the center of the longest wall 916 among walls of a space 915 (e.g., a living room or a bedroom).

According to an embodiment, when the object 960 may not be arranged at the center of the wall 916, the electronic device may sequentially arrange objects starting from the region closest to the center of the wall 916 among arrangeable regions.

FIG. 10A is a view illustrating an operation of automatically arranging an object corresponding to an IoT device whose location is difficult to infer by an electronic device according to an embodiment.

Referring to FIG. 10A, an electronic device (e.g., the device 124 of FIG. 1, the electronic device 201 of FIG. 2, the processor 220 of FIG. 1, or the electronic device 310 of FIG. 3) may search from the longest wall of a room and arrange objects corresponding to IoT devices one by one starting from the left corner of the wall. The electronic device may search for the longest wall based on the length of the wall except for doors. The electronic device may treat windows as walls. When a plurality of walls of the same length are found, the electronic device may preferentially arrange objects on the right wall and the bottom wall.

According to an embodiment, the electronic device may arrange a first object 1020 at the end of the longest wall 1011 except for doors among the walls 1011, 1012, 1013, 1014, except for a portion 1015 without a wall in the room 1010.

According to an embodiment, the electronic device may arrange a second object 1021 at a position far from the first object 1020 among the ends of the second longest wall 1012.

According to an embodiment, when objects are arranged one by one on all walls 1011, 1012, 1013, 1014 of the room 1010, the electronic device may arrange objects at the other end where objects are not arranged, starting from the longest wall 1011 again. According to an embodiment, the electronic device may not arrange objects in portions that are less than a set distance from already arranged objects.

According to an embodiment, as illustrated in FIG. 10A, when objects are arranged one by one at two opposite ends of all walls 1011, 1012, 1013, 1014 of 1010, the electronic device may arrange objects one by one between the already arranged objects as illustrated in FIG. 10B.

FIG. 10B is a view illustrating an operation of automatically arranging an object corresponding to an IoT device whose location is difficult to infer by an electronic device according to an embodiment.

Referring to FIG. 10B, the electronic device may arrange an object 1030 between objects arranged at two opposite ends of the longest wall. According to an embodiment, the electronic device may arrange an object 1031 between objects arranged at two opposite ends of the second longest wall.

According to an embodiment, when objects are arranged on all walls of a room, the electronic device may arrange objects parallel to the walls in the inward direction of the room.

Thus, since IoT devices are often arranged on walls, similarity between the actual location of devices and the location of objects may be expected, and by arranging objects at intervals on walls, erroneous input may be prevented when users adjust positions.

FIG. 11A is a view illustrating an operation of assigning a pre-registered room to an indoor map through an IoT application of an electronic device according to an embodiment.

Referring to FIG. 11A, an electronic device (e.g., the device 124 of FIG. 1, the electronic device 201 of FIG. 2, the processor 220 of FIG. 1, or the electronic device 310 of FIG. 3) may display an indoor map and an IoT device list not assigned to the indoor map. According to an embodiment, the IoT device list may be grouped by room type.

According to an embodiment, the electronic device may receive an input 1121 that selects a UI 1110 corresponding to a room (e.g., bedroom) not assigned to the indoor map and drags it to a region 1120 on the indoor map where a room is not assigned.

According to an embodiment, the electronic device may display objects corresponding to IoT devices included in the selected room in the region 1120 where the drag is released.

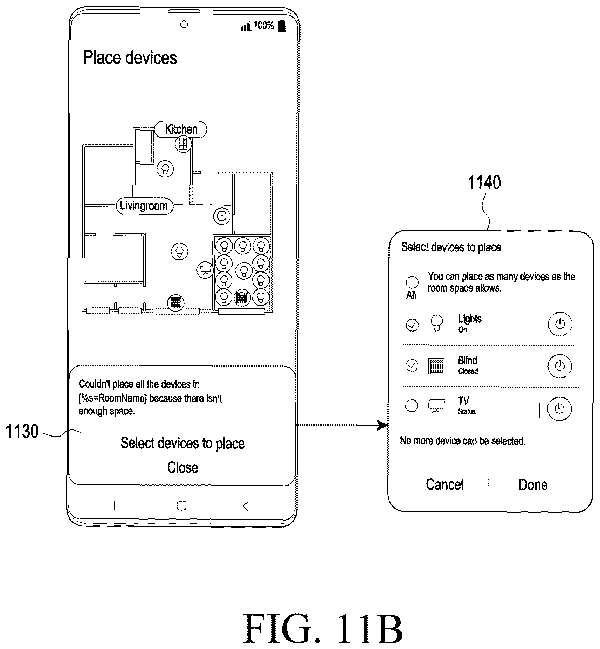

According to an embodiment, when the size of the region 1120 is too small to display all objects, the electronic device may display a screen for selecting objects to be displayed in the region 1120, as illustrated in FIG. 11B.

FIG. 11B is a view illustrating an operation of assigning objects corresponding to IoT devices included in a pre-registered room to an indoor map through an IoT application of an electronic device according to an embodiment.

Referring to FIG. 11B, when the size of a region is too small to display all objects, the electronic device may display a message 1130 indicating that there is insufficient space to display all objects. The message 1130 may include a UI for selecting objects to be displayed.

According to an embodiment, when a user input selecting the UI for selecting objects to be displayed is received, the electronic device may display a screen 1140 for selecting objects to be displayed. For example, the screen 1140 for selecting objects to be displayed may be a pop-up screen.

According to an embodiment, the electronic device may allow only a limited number of objects to be selectable among a plurality of objects through the screen 1140 for selecting objects to be displayed.

According to an embodiment, the electronic device may display objects selected by the user in the region 1120 to which the room is assigned. According to an embodiment, the displayed objects may be automatically arranged in the manner illustrated in FIGS. 9A to 10B.

FIG. 12 is a view illustrating an operation of selecting objects to be displayed on an indoor map when assigning a pre-registered room to the indoor map through an IoT application of an electronic device according to an embodiment.

Referring to FIG. 12, when a room (e.g., living room) is assigned to a region 1210 of an indoor map, an electronic device (e.g., the device 124 of FIG. 1, the electronic device 201 of FIG. 2, the processor 220 of FIG. 1, or the electronic device 310 of FIG. 3) may display a different color from other regions in the region to which the room is assigned and display the name of the room. According to an embodiment, the electronic device may arrange objects corresponding to IoT devices included in the room within the region 1210 to which the room is assigned.

According to an embodiment, the electronic device may select objects to be displayed in the region 1210 based on a user input.

According to an embodiment, when a user input 1211 selecting a region 1210 on the indoor map is received, the electronic device may display a screen 1220 for editing objects. According to an embodiment, the screen 1220 for editing objects may include a UI for selecting objects to be displayed and a UI for hiding objects.

According to an embodiment, when receiving a user input 1221 selecting the UI for selecting objects to be displayed, the electronic device may display a screen 1230 for selecting objects to be displayed on the indoor map.

According to an embodiment, the electronic device may display all objects that may be displayed in the region 1210 to which the room is assigned through the screen 1230 for selecting objects to be displayed in the region 1210 to which the room is assigned, and may receive a user's selection.

According to an embodiment, the electronic device may display objects selected by the user in the region 1210 to which the room is assigned. According to an embodiment, the displayed objects may be automatically arranged in the manner illustrated in FIGS. 9A to 10B.

FIG. 13A is a view illustrating an operation of changing the location of a room assigned on an indoor map of an electronic device according to an embodiment.

Referring to FIG. 13A, when a room (e.g., living room) is assigned to a first region 1310 of an indoor map, an electronic device (e.g., the device 124 of FIG. 1, the electronic device 201 of FIG. 2, the processor 220 of FIG. 1, or the electronic device 310 of FIG. 3) may display a different color from other regions in the region to which the room is assigned and display the name of the room. According to an embodiment, the electronic device may arrange objects corresponding to IoT devices included in the room within the first region 1310 to which the room is assigned.

According to an embodiment, the electronic device may receive a user input 1311 that long presses the first region 1310 and drags it to a second region 1320. The second region 1320 may be a region to which no room is assigned.

According to an embodiment, based on the user input 1311 that long presses the first region 1310 and drags it to the second region 1320, the electronic device may reassign the room assigned to the first region 1310 to the second region 1320. According to an embodiment, the electronic device may delete objects that were displayed in the first region 1310 from the first region 1310 and display objects 1330 corresponding to IoT devices included in the room reassigned to the second region 1320. According to an embodiment, the displayed objects 1330 may be automatically arranged in the manner illustrated in FIGS. 9A to 10B.

FIG. 13B is a view illustrating an operation of deleting a room assigned on an indoor map of an electronic device according to an embodiment.

Referring to FIG. 13B, when receiving a user input 1313 that long presses a region to which a room is assigned on an indoor map and drags it to an unarranged list area 1340, the electronic device may unassign the room from a region of the indoor map. According to an embodiment, the unarranged list area 1340 may be a list of rooms and/or IoT devices not assigned to the indoor map.

According to an embodiment, based on the user input 1313 that long presses the region to which a room is assigned on the indoor map and drags it to the unarranged list area 1340, the electronic device may unassign the room from the first region 1310, and information about the unassigned room may be added to the unarranged list area 1340.

FIG. 14A is a view illustrating an operation of changing the location of a room assigned on an indoor map of an electronic device according to an embodiment.

Referring to FIG. 14A, when a first room (e.g., living room) is assigned to a first region 1410 and a second room (e.g., kitchen) is assigned to a second region 1420 of an indoor map, an electronic device (e.g., the device 124 of FIG. 1, the electronic device 201 of FIG. 2, the processor 220 of FIG. 1, or the electronic device 310 of FIG. 3) may display the first region 1410 and the second region 1420 in different colors and display the name of each room. According to an embodiment, the electronic device may arrange objects corresponding to IoT devices included in the first room within the first region 1410, and arrange objects corresponding to IoT devices included in the second room within the second region 1420.

According to an embodiment, the electronic device may receive a user input 1411 that long presses the first region 1410 and drags it to the second region 1420.

According to an embodiment, based on the user input 1411 that long presses the first region 1410 and drags it to the second region 1420, the electronic device may provide options to switch or merge the rooms assigned to each region, as illustrated in FIG. 14B.

FIG. 14B is a view illustrating a user interface displayed when an input for changing the location of a room assigned on an indoor map of an electronic device to a location where another room is already assigned is received according to an embodiment.

Referring to FIG. 14B, based on the user input 1411 that long presses the first region 1410 and drags it to the second region 1420, the electronic device may display a screen 1430 (e.g., a pop-up screen) including a UI 1431 for switching rooms assigned to each region and a UI 1432 for merging two rooms into one region.

According to an embodiment, based on the UI 1431 for switching rooms assigned to each region being selected, the electronic device may switch the rooms assigned to each region, as illustrated in FIG. 14C.

According to an embodiment, based on the UI 1432 for merging two rooms into one region being selected, the electronic device may assign the two rooms to one room as illustrated in FIGS. 15A to 15C below. The operation of merging two rooms into one region is described in more detail with reference to FIGS. 15A to 15C below.

FIG. 14C is a view illustrating an operation of switching locations of a plurality of rooms assigned on an indoor map of an electronic device according to an embodiment.

Referring to FIG. 14C, based on the UI 1431 for switching rooms assigned to each region being selected, the electronic device may assign the second room (e.g., kitchen) to the first region 1410 and assign the first room (e.g., living room) to the second region 1420. According to an embodiment, the electronic device may delete objects that were displayed in the first region 1410 from the first region 1410 and display them in the second region 1420. According to an embodiment, the electronic device may delete objects that were displayed in the second region 1420 from the second region 1420 and display them in the first region 1410. According to an embodiment, objects displayed in the first region 1410 and the second region 1420 may be automatically arranged in the manner illustrated in FIGS. 9A to 10B.

According to an embodiment, when at least one of the first region 1410 and the second region 1420 has insufficient space to display objects, as illustrated in FIG. 11B, the electronic device may display a message notifying of insufficient space and display a screen for selecting objects to be displayed.

FIG. 15A is a view illustrating an operation of merging a plurality of rooms on an indoor map of an electronic device according to an embodiment.

Referring to FIG. 15A, when a first room (e.g., living room) is assigned to a first region 1510 and a second room (e.g., kitchen) is assigned to a second region 1520 of an indoor map, an electronic device (e.g., the device 124 of FIG. 1, the electronic device 201 of FIG. 2, the processor 220 of FIG. 1, or the electronic device 310 of FIG. 3) may display the first region 1510 and the second region 1520 in different colors and display the name of each room. According to an embodiment, the electronic device may arrange objects corresponding to IoT devices included in the first room within the first region 1510, and arrange objects corresponding to IoT devices included in the second room within the second region 1520.

According to an embodiment, the electronic device may further display an unarranged list 1530 displaying rooms and/or IoT devices not assigned to the indoor map.

According to an embodiment, the electronic device may receive a user input 1532 that selects a UI 1531 corresponding to a third room (e.g., bedroom) included in the unarranged list 1530 and drags it to the first region 1510.

According to an embodiment, based on the user input 1532 that selects the UI 1531 corresponding to the third room and drags it to the first region 1510, the electronic device may provide options to switch or merge the rooms assigned to each region, as illustrated in FIG. 15B.

FIG. 15B is a view illustrating a user interface displayed when an input for merging a plurality of rooms on an indoor map of an electronic device is received according to an embodiment.

Referring to FIG. 15B, based on the user input 1532 that selects the UI 1531 corresponding to the third room and drags it to the first region 1510, the electronic device may display a screen 1540 (e.g., a pop-up screen) including a UI 1541 for switching rooms assigned to each region and a UI 1542 for merging two rooms into one region.

According to an embodiment, based on the UI 1542 for merging two rooms into one region being selected, the electronic device may assign two rooms (e.g., living room and bedroom) to the first region 1510. According to an embodiment, the electronic device may display a screen 1550 for entering a name to be displayed in the first region 1510 to which two rooms are assigned, as illustrated in FIG. 15C.

According to an embodiment, based on the UI 1541 for switching rooms assigned to each region being selected, the electronic device may switch the assigned regions of the two rooms as illustrated in FIGS. 14A to 14C. For example, the electronic device may assign the third room to the first region 1510, and the assignment of the first room may be released, and a UI for the first room may be included in the unarranged list 1530.

FIG. 15C is a view illustrating a user interface displayed for modifying a room name when an input for merging a plurality of rooms on an indoor map of an electronic device is received according to an embodiment.

Referring to FIG. 15C, the screen 1550 for entering a name to be displayed in the first region 1510 may include an area 1551 for text input. According to an embodiment, the electronic device may determine text entered in the area 1551 for text input as the name of the first region 1510. According to an embodiment, the screen 1550 for entering a name to be displayed in the first region 1510 may include, together with or instead of the area 1551 for text input, a UI for selecting one of the names of the two rooms.

According to an embodiment, the electronic device may arrange objects corresponding to IoT devices included in the first room and objects corresponding to IoT devices included in the third room within the first region 1510. According to an embodiment, objects displayed in the first region 1510 may be automatically arranged in the manner illustrated in FIGS. 9A to 10B.

According to an embodiment, when the first region 1510 has insufficient space to display objects, as illustrated in FIG. 11B, the electronic device may display a message notifying of insufficient space and display a screen for selecting objects to be displayed.

FIG. 16A is a view illustrating an operation of arranging an object corresponding to an IoT device not registered in any room on an indoor map through an IoT application of an electronic device according to an embodiment.

Referring to FIG. 16A, an electronic device (e.g., the device 124 of FIG. 1, the electronic device 201 of FIG. 2, the processor 220 of FIG. 1, or the electronic device 310 of FIG. 3) may receive a user input 1611 dragging a UI 1610 corresponding to an IoT device included in an unarranged list to a first region 1620 of an indoor map. According to an embodiment, a first room (e.g., living room) may be assigned to the first region 1620.

According to an embodiment, the electronic device may arrange an object 1612 corresponding to the dragged UI 1610 at a position where the user input 1611 is released. For example, the object 1612 may be an icon of an IoT device corresponding to the selected UI 1610.

FIG. 16B is a view illustrating an operation of arranging an object corresponding to an IoT device not registered in any room on an indoor map through an IoT application of an electronic device according to an embodiment.

Referring to FIG. 16B, the electronic device may receive a user input 1613 dragging a UI 1610 corresponding to an IoT device included in an unarranged list to a second region 1630 of an indoor map. According to an embodiment, no room may be assigned to the second region 1630.

According to an embodiment, the electronic device may display a screen 1640 for entering a room name to assign a new room to the second region 1630. For example, the screen 1640 for entering a room name may include an area 1641 for entering text and/or a plurality of UIs for selecting a room name.

According to an embodiment, the electronic device may display the name entered or selected through the screen 1640 for entering a room name in the second region 1630. According to an embodiment, the electronic device may arrange an object corresponding to the dragged UI 1610 at a position in the second region 1630 where the user input 1611 is released. For example, the object may be an icon of an IoT device corresponding to the selected UI 1610.

FIG. 17A is a view illustrating an operation of changing the form of an object of an electronic device according to an embodiment.

Referring to FIG. 17A, an electronic device (e.g., the device 124 of FIG. 1, the electronic device 201 of FIG. 2, the processor 220 of FIG. 1, or the electronic device 310 of FIG. 3) may receive a user input 1711 selecting an object 1710 arranged in a first region on an indoor map. For example, the user input 1711 may be a long press.

According to an embodiment, the electronic device may display a screen 1720 for editing the object 1710 based on the user input 1711 selecting the object 1710. According to an embodiment, the screen 1720 for editing the object 1710 may include a UI for changing an icon form and a UI for hiding an icon.

According to an embodiment, when selecting an object 1730 whose icon form may not be changed, the electronic device may display only a UI for hiding an icon in the screen 1731 for editing the object 1730.

FIG. 17B is a view illustrating an operation of changing the form of an object of an electronic device according to an embodiment.

Referring to FIG. 17B, the electronic device may display an icon list 1740 based on receiving a user input 1721 selecting a UI for changing an icon form in the screen 1720 for editing the object 1710.

According to an embodiment, based on receiving a user input 1741 selecting one icon from the icon list 1740, the electronic device may display an object 1742 changed to the selected icon.

According to an embodiment, based on receiving a user input 1722 selecting a UI for hiding an icon in the screen 1720 for editing the object 1710, the electronic device may delete an icon displayed on the indoor map. According to an embodiment, the icon is deleted from the indoor map, but the registration of the IoT device corresponding to the deleted object may be maintained.

FIG. 18 is a flowchart illustrating an operation of generating an indoor map on which objects are arranged by an electronic device according to an embodiment.

Referring to FIG. 18, in operation 1810, an electronic device (e.g., the device 124 of FIG. 1, the electronic device 201 of FIG. 2, the processor 220 of FIG. 1, or the electronic device 310 of FIG. 3) may obtain an account (e.g., ID) based indoor map. For example, the indoor map may be obtained based on address information stored in the account.

According to an embodiment, in operation 1820, the electronic device may identify whether a map has already been generated. That a map has been generated may mean that objects corresponding to IoT devices registered in the account have been automatically arranged on the indoor map, or manually arranged by a user input and saved.

According to an embodiment, if a map has already been generated (operation 1820-Yes), the electronic device may terminate the process for generating an indoor map.

According to an embodiment, if a map has not been generated (operation 1820-No), in operation 1830, the electronic device may identify whether map data has been changed. For example, the map data may correspond to a floor plan selected by a user input from among at least one floor plan. According to an embodiment, when a user input changing the floor plan is received, the electronic device may identify that the map data has been changed.

According to an embodiment, if the map data has been changed (operation 1830-Yes), in operation 1831, the electronic device may transmit the map data to a server (e.g., the first IoT server 110 of FIG. 1, the server 208 of FIG. 2, or the server 320 of FIG. 3). For example, the electronic device may transmit the map data selected for the space for generating the indoor map to the server.

According to an embodiment, after operation 1831, in operation 1840, the electronic device may identify whether room and/or device data has been changed. According to an embodiment, if the map data has not been changed (operation 1830-No), the electronic device may proceed to operation 1840.

According to an embodiment, whether room and/or device data has been changed may be whether pre-registered rooms and IoT devices grouped by room have been changed (e.g., added, deleted, or renamed) by a user input.

According to an embodiment, if room and/or device data has been changed (operation 1840-Yes), in operation 1841, the electronic device may transmit room and device data to the server. For example, information about room and device data may be information about whether data about rooms and/or devices has been changed.

After operation 1841, in operation 1850, the electronic device may identify whether room assignment regions have been changed. According to an embodiment, if room and/or device data has not been changed (operation 1840-No), the electronic device may proceed to operation 1850.

According to an embodiment, whether room assignment regions have been changed may be whether regions to which rooms are assigned among regions of the indoor map have been changed by a user input. For example, the electronic device may assign a room to a region where the type of the region on the indoor map matches the name of a pre-registered room. For example, the electronic device may assign a pre-registered room "living room" to a region whose type is "living room" on the indoor map.

According to an embodiment, the electronic device may change (e.g., add, delete, or move) room assignment regions based on user input, as illustrated in FIGS. 11A to 16.

According to an embodiment, if room assignment regions have been changed (operation 1850-Yes), in operation 1851, the electronic device may transmit room assignment information to the server. For example, the room assignment information may be information about whether room assignment regions have been changed.

After operation 1851, in operation 1860, the electronic device may identify whether devices have been moved. According to an embodiment, if room assignment regions have not been changed (operation 1850-No), the electronic device may proceed to operation 1860.

According to an embodiment, whether devices have been moved may be whether objects corresponding to devices arranged on the indoor map have been moved by a user input.

According to an embodiment, if devices have been moved (operation 1860-Yes), in operation 1861, the electronic device may transmit room assignment information to the server.

After operation 1861, in operation 1870, the electronic device may store map data for rooms and devices. According to an embodiment, if devices have not been moved (operation 1860-No), the electronic device may proceed to operation 1870.

According to an embodiment, in operation 1871, the electronic device may transmit room and device coordinates for the map data to the server. Although FIG. 18 illustrates that coordinate information is transmitted after transmitting information about whether changes have been made, according to an embodiment, coordinate information may be transmitted when transmitting information about whether each change has been made.

According to an embodiment, the order of operations for identifying whether changes have been made is not limited to FIG. 18.

FIG. 19 is a flowchart illustrating an indoor map control operation of another user based on the authority of the other user according to an embodiment.

Referring to FIG. 19, an owner 1920 who is a user of an electronic device (e.g., the device 124 of FIG. 1, the electronic device 201 of FIG. 2, the processor 220 of FIG. 1, or the electronic device 310 of FIG. 3) may grant permission for the indoor map to another user (member). For example, the permission may be full permission, limited permission, or no permission. For example, full permission allows identifying the status and notifications of all IoT devices through the indoor map and controlling IoT devices with the same authority as the owner. Full permission allows editing the indoor map, such as assigning rooms registered by a user input to the indoor map or arranging IoT devices on the indoor map, and may also delete the generated indoor map.

For example, limited permission allows identifying the status and notifications of all IoT devices through the indoor map and controlling IoT devices. Limited permission may not edit or delete the indoor map.

For example, no permission makes all functions for the indoor map unavailable, and the indoor map may not be viewable.

According to an embodiment, the owner 1920 may grant permission to another user through a user input 1921 through a screen (e.g., a permission setting screen) of an application 1910.

According to an embodiment, the application 1910 may register 1922 the permission granted to each user in a permission server 1911.

According to an embodiment, when the owner or another user 1930 executes the indoor map through the application 1910, the application 1910 may request 1932 permission information from the permission server 1911 and receive permission information from the permission server 1911.

For example, when the permission is full permission or limited permission, the application 1910 may request 1933 the indoor map from a map data server 1912 and receive 1934 the indoor map from the map data server 1912.

According to an embodiment, the application 1910 may provide the indoor map.

For example, in the case of no permission, the application 1910 does not request the indoor map from the map data server 1912 and may not provide the indoor map.

According to an embodiment, when the permission is full permission or limited permission, after providing map data, the application 1910 may request 1935 status and/or device control of IoT devices from a device server 1913 (e.g., an IoT device server) based on a user input. According to an embodiment, the application 1910 may receive 1936 success or failure of IoT device control and/or status information of IoT devices from the device server 1913. According to an embodiment, the application 1910 may provide (e.g., display) the received control success or failure and/or status information of IoT devices.

According to an embodiment, when the permission is full permission or limited permission, the application 1910 may request 1937 notifications of IoT devices from the device server 1913 based on a user input. According to an embodiment, the application 1910 may receive 1938 notifications of IoT devices from the device server 1913 and provide (e.g., display) the notifications.

FIG. 20 is a view illustrating an editing menu provided to another user based on the authority of the other user according to an embodiment.

Referring to FIG. 20, an electronic device of another user (member) may provide indoor map-related functions based on authority granted by an owner. For example, when the authority of the other user is full permission, when the electronic device of the other user selects a menu 2010, a screen 2020 for editing the indoor map may be displayed. For example, the screen 2020 for editing the indoor map may include a UI for editing layout, a UI for placing devices, and a UI for deleting the map.

According to an embodiment, when the authority of the other user is limited permission, the screen 2020 for editing may not be provided.

Thus, by providing floor plan-based map data and providing a customization function, an indoor map similar to the space actually used by the user may be provided.

Although the disclosure illustrates the indoor map being displayed on a terminal, a 2D map or a 3D map may also be applied to large screens (e.g., TVs, billboards), XR devices, and robots, providing rich experiences.

According to an embodiment, an electronic device may include a communication module, a display, and at least one processor operatively connected to the communication module and the display.

According to an embodiment, the at least one processor may obtain an indoor map based on a user account through the communication module.

According to an embodiment, the at least one processor may automatically arrange, on the indoor map, at least one object corresponding respectively to at least one external electronic device registered in the user account.

According to an embodiment, the at least one processor may display, on the display, the indoor map on which the at least one object is arranged.

According to an embodiment, the at least one processor may rearrange the one object based on receiving a user input for moving a location of one object among the at least one object.

According to an embodiment, the at least one processor may automatically arrange the at least one object at a set location on the indoor map based on a set condition corresponding to a type of the at least one external electronic device.

According to an embodiment, the at least one processor may arrange an object corresponding to an external electronic device which does not have a set location among the at least one external electronic device, in a corner region of a space included in the indoor map.

According to an embodiment, the at least one processor may arrange an object corresponding to an external electronic device which does not have a set location among the at least one external electronic device, in a corner region of the longest wall among walls constituting a space included in the indoor map.

According to an embodiment, the at least one processor may share the indoor map, on which the at least one object is arranged, with an external electronic device through the communication module.

According to an embodiment, the at least one processor may rearrange at least one space among a plurality of spaces included in the indoor map based on receiving a user input for rearranging a space of the indoor map.

According to an embodiment, the at least one processor may obtain a floor plan image based on address information corresponding to the user account and obtain the indoor map based on the floor plan image.

According to an embodiment, the electronic device may further include memory.

According to an embodiment, the at least one processor may recognize a structure of a space including at least one of a room, a wall, or a door included in the floor plan image based on a deep learning model stored in the memory.

According to an embodiment, the deep learning model may be trained to obtain a structure of a space as output data using a floor plan image as input data.

According to an embodiment, the at least one processor may classify a purpose of each of a plurality of spaces included in the indoor map based on the structure of the space.

According to an embodiment, a method of controlling an electronic device may include obtaining an indoor map based on a user account through a communication module of the electronic device.

According to an embodiment, the method of controlling the electronic device may include automatically arranging, on the indoor map, at least one object corresponding respectively to at least one external electronic device registered in the user account.

According to an embodiment, the method of controlling the electronic device may include displaying the indoor map on which the at least one object is arranged.

According to an embodiment, the method of controlling the electronic device may further include rearranging the one object based on receiving a user input for moving a location of one object among the at least one object.

According to an embodiment, automatically arranging the at least one object on the indoor map may automatically arrange the at least one object at a set location on the indoor map based on a set condition corresponding to a type of the at least one external electronic device.

According to an embodiment, automatically arranging the at least one object on the indoor map may arrange an object corresponding to an external electronic device which does not have a set location among the at least one external electronic device, in a corner region of a space included in the indoor map.

According to an embodiment, automatically arranging the at least one object on the indoor map may arrange an object corresponding to an external electronic device which does not have a set location among the at least one external electronic device, in a corner region of the longest wall among walls constituting a space included in the indoor map.

According to an embodiment, the method of controlling the electronic device may further include sharing the indoor map, on which the at least one object is arranged, with an external electronic device through the communication module.

According to an embodiment, the method of controlling the electronic device may further include rearranging at least one space among a plurality of spaces included in the indoor map based on receiving a user input for rearranging a space of the indoor map.

According to an embodiment, the obtaining the indoor map may obtain a floor plan image based on address information corresponding to the user account and obtain the indoor map based on the floor plan image.

According to an embodiment, the obtaining the indoor map may recognize a structure of a space including at least one of a room, a wall, or a door included in the floor plan image based on a deep learning model stored in memory of the electronic device.

According to an embodiment, the deep learning model may be trained to obtain a structure of a space as output data using a floor plan image as input data.

According to an embodiment, the obtaining the indoor map may classify a purpose of each of a plurality of spaces included in the indoor map based on the structure of the space.

According to an embodiment, in a non-transitory computer-readable recording medium storing one or more programs, the one or more programs may include instructions for an electronic device to obtain an indoor map based on a user account through a communication module.

According to an embodiment, the one or more programs may include instructions for the electronic device to automatically arrange, on the indoor map, at least one object corresponding respectively to at least one external electronic device registered in the user account.

According to an embodiment, the one or more programs may include instructions for the electronic device to display, on the display, the indoor map on which the at least one object is arranged.

According to an embodiment, the one or more programs may include instructions for the electronic device to rearrange the one object based on receiving a user input for moving a location of one object among the at least one object.

According to an embodiment, the one or more programs may include instructions for the electronic device to automatically arrange the at least one object at a set location on the indoor map based on a set condition corresponding to a type of the at least one external electronic device.

According to an embodiment, the one or more programs may include instructions for the electronic device to arrange an object corresponding to an external electronic device which does not have a set location among the at least one external electronic device, in a corner region of a space included in the indoor map.

According to an embodiment, the one or more programs may include instructions for the electronic device to arrange an object corresponding to an external electronic device which does not have a set location among the at least one external electronic device, in a corner region of the longest wall among walls constituting a space included in the indoor map.

According to an embodiment, the one or more programs may include instructions for the electronic device to share the indoor map, on which the at least one object is arranged, with an external electronic device through the communication module.

According to an embodiment, the one or more programs may include instructions for the electronic device to rearrange at least one space among a plurality of spaces included in the indoor map based on receiving a user input for rearranging a space of the indoor map.

According to an embodiment, the one or more programs may include instructions for the electronic device to obtain a floor plan image based on address information corresponding to the user account and obtain the indoor map based on the floor plan image.

According to an embodiment, the electronic device may further include memory.

According to an embodiment, the one or more programs may include instructions for the electronic device to recognize a structure of a space including at least one of a room, a wall, or a door included in the floor plan image based on a deep learning model stored in the memory.

According to an embodiment, the deep learning model may be trained to obtain a structure of a space as output data using a floor plan image as input data.

According to an embodiment, the one or more programs may include instructions for the electronic device to classify a purpose of each of a plurality of spaces included in the indoor map based on the structure of the space.

The electronic device according to an embodiment may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

An embodiment of the disclosure may be implemented as software (e.g., the program 240) including one or more instructions that are stored in a storage medium (e.g., internal memory 236 or external memory 238) that is readable by a machine (e.g., the electronic device 201). For example, a processor (e.g., the processor 220) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The storage medium readable by the machine may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program products may be traded as commodities between sellers and buyers. The computer program product may be distributed in the form of a machine-readable storage medium (e.g., compact disc read only memory (CD-ROM)), or be distributed (e.g., downloaded or uploaded) online via an application store (e.g., Play Store^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to an embodiment, each component (e.g., a module or a program) of the above-described components may include a single entity or multiple entities. Some of the plurality of entities may be separately disposed in different components. According to an embodiment, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device, comprising:
a communication module;
a display; and
at least one processor operatively connected to the communication module and the display, wherein the at least one processor is configured to:
obtain, through the communication module, an indoor map based on a user account;
automatically arrange, on the indoor map, at least one object corresponding respectively to at least one external electronic device registered in the user account; and
display, on the display, the indoor map on which the at least one object is arranged.

2. The electronic device of claim 1, wherein the at least one processor is configured to, based on receiving a user input for moving a location of one object among the at least one object, rearrange the one object.

3. The electronic device of claim 1 or 2, wherein the at least one processor is configured to automatically arrange the at least one object at a set location on the indoor map based on a set condition corresponding to a type of the at least one external electronic device.

4. The electronic device of claim 3, wherein the at least one processor is configured to arrange an object corresponding to an external electronic device which does not have a set location among the at least one external electronic device, in a corner region of a space included in the indoor map.

5. The electronic device of claim 4, wherein the at least one processor is configured to arrange an object corresponding to an external electronic device which does not have a set location among the at least one external electronic device, in a corner region of the longest wall among walls constituting a space included in the indoor map.

6. The electronic device of any one of claims 1 to 5, wherein the at least one processor is configured to share the indoor map, on which the at least one object is arranged, with an external electronic device through the communication module.

7. The electronic device of any one of claims 1 to 6, wherein the at least one processor is configured to rearrange at least one space among a plurality of spaces included in the indoor map based on receiving a user input for rearranging a space of the indoor map.

8. The electronic device of any one of claims 1 to 7, wherein the at least one processor is configured to obtain a floor plan image based on address information corresponding to the user account, and obtain the indoor map based on the floor plan image.

9. The electronic device of claim 8, further comprising memory, wherein the at least one processor is configured to recognize, based on a deep learning model stored in the memory, a structure of a space including at least one of a room, a wall, or a door included in the floor plan image, wherein the deep learning model is trained to obtain a structure of a space as output data by using a floor plan image as input data.

10. The electronic device of claim 9, wherein the at least one processor is configured to classify a purpose of each of a plurality of spaces included in the indoor map, based on the structure of the space.

11. A method of controlling an electronic device, the method comprising:
obtaining, through a communication module of the electronic device, an indoor map based on a user account;
automatically arranging, on the indoor map, at least one object corresponding respectively to at least one external electronic device registered in the user account; and
displaying the indoor map on which the at least one object is arranged.

12. The method of claim 11, further comprising, based on receiving a user input for moving a location of one object among the at least one object, rearranging the one object.

13. The method of claim 11 or 12, wherein the automatically arranging the at least one object on the indoor map comprises automatically arranging the at least one object at a set location on the indoor map based on a set condition corresponding to a type of the at least one external electronic device.

14. The method of claim 13, wherein the automatically arranging the at least one object on the indoor map comprises arranging an object corresponding to an external electronic device which does not have a set location among the at least one external electronic device, in a corner region of a space included in the indoor map.

15. The method of claim 14, wherein the automatically arranging the at least one object on the indoor map comprises arranging an object corresponding to an external electronic device which does not have a set location among the at least one external electronic device, in a corner region of the longest wall among walls constituting a space included in the indoor map.
